# EUROPEAN PATENT APPLICATION

(11) **EP 4 770 307 A1**
(43) Date of publication of application: **01.07.2026**
(21) Application number: 25227485.7
(22) Date of filing: 29.12.2025
(51) Int. Cl.: H10B 12/00

(54) **SEMICONDUCTOR DEVICES**

(30) Priority: 30.12.2024 KR 20240200932
(71) Applicant: Samsung Electronics Co., Ltd., Suwon-si, Gyeonggi-do 16677 (KR)
(72) Inventor: PARK, Sanghyun, 16677 Suwon-si (KR); HWANG, Hyungjun, 16677 Suwon-si (KR); KIM, Jonghoon, 16677 Suwon-si (KR); LEE, Namhoon, 16677 Suwon-si (KR); LEE, Youngjae, 16677 Suwon-si (KR); CHUNG, Chunhyung, 16677 Suwon-si (KR)
(74) Representative: Marks & Clerk LLP

(57) **Abstract**

A semiconductor device includes a bit line structure, first and second gate structures and a channel. The bit line structure extends in a first direction. The first gate structure includes a first gate electrode extending in a second direction, a gate barrier pattern on the first gate electrode, a capping pattern on the gate barrier pattern, and a first gate insulation pattern on the bit line structure. The first gate insulation pattern is on sidewalls of the first gate electrode, the gate barrier pattern and the capping pattern. The channel extends in a third direction on a sidewall of the first gate structure. The second gate structure includes a second gate insulation pattern and a second gate electrode on the bit line structure. The second gate insulation pattern is on a sidewall of the channel. The second gate electrode is on a sidewall of the second gate insulation pattern.

## Description

### BACKGROUND

### 1. Technical Field

Example embodiments of the present disclosure relate to semiconductor devices. More particularly, example embodiments of the present disclosure relate to memory devices including a vertical channel.

### 2. Discussion of Related Art

In order to improve an integration degree of a semiconductor device, a memory device including a vertical channel transistor has been developed. The vertical channel transistor includes a channel extending in a vertical direction, a first gate electrode serving as a word line, and a second gate electrode for controlling a threshold voltage of the channel.

### SUMMARY

Example embodiments provide semiconductor devices having improved characteristics.

According to an example embodiment, a semiconductor device includes a bit line structure extending in a first direction, a first gate structure including a first gate electrode extending in a second direction crossing the first direction, the first gate electrode being on the bit line structure, a gate barrier pattern on the first gate electrode, the gate barrier pattern including nitride, a capping pattern on the gate barrier pattern, the capping pattern including oxide, a first gate insulation pattern on the bit line structure, the first gate insulation pattern being on sidewalls in the first direction of the first gate electrode, the gate barrier pattern and the capping pattern, a channel on the bit line structure, the channel extending in a third direction perpendicular to the first and second directions on a sidewall in the first direction of the first gate structure, and a second gate structure including a second gate insulation pattern on the bit line structure, the second gate insulation pattern being on a sidewall in the first direction of the channel, and a second gate electrode on the bit line structure, the second gate electrode being on a sidewall in the first direction of the second gate insulation pattern.

According to an example embodiment, a semiconductor device includes a bit line structure extending in a first direction, a first insulation pattern, a first gate electrode, a gate barrier pattern and a capping pattern sequentially stacked in a third direction on the bit line structure, each of the first insulation pattern, the first gate electrode, the gate barrier pattern and the capping pattern extending in a second direction crossing the first direction, and the third direction being perpendicular to the first and second directions, a first gate insulation pattern on the bit line structure, the first gate insulation pattern being on sidewalls in the first direction of the first insulation pattern, the first gate electrode, the gate barrier pattern and the capping pattern, a channel on the bit line structure, the channel extending in the third direction on a sidewall in the first direction of the first gate insulation pattern, a second gate insulation pattern on the bit line structure, the second gate insulation pattern being on a sidewall in the first direction of the channel, and a second gate electrode on the bit line structure, the second gate electrode being on a sidewall in the first direction of the second gate insulation pattern, wherein the gate barrier pattern includes a first insulating material, and the capping pattern includes a second insulating material different from the first insulating material.

According to an example embodiment, a semiconductor device includes bit line structures spaced apart from each other in a first direction, each of the bit line structures extending in a second direction crossing the first direction, a first insulation pattern on the bit line structures and extending in the first direction, the first insulation pattern including a first insulating material, a first gate electrode on the first insulation pattern and extending in the first direction, a gate barrier pattern on the first gate electrode and extending in the first direction, the gate barrier pattern including nitride, a capping pattern on the gate barrier pattern and extending in the first direction, the capping pattern including oxide, first gate insulation patterns on the bit line structures, the first gate insulation patterns being on opposite sidewalls in the second direction of each of the first insulation pattern, the first gate electrode, the gate barrier pattern and the capping pattern, respectively, channels on the bit line structures, the channels being on sidewalls in the second direction of the first gate insulation patterns, respectively, each of the channels extending in a third direction perpendicular to the first and second directions, contact plugs on the channels, respectively, second gate insulation patterns on the bit line structures, the second gate insulation patterns on sidewalls in the second direction of the channels, respectively, and each of the second gate insulation patterns extending in the first direction, second insulation patterns on the bit line structures, the second gate insulation patterns being on sidewalls in the second direction of the second gate insulation patterns, respectively, and each of the second insulation patterns extending in the first direction and including a second insulating material, second gate electrodes on the second insulation patterns, respectively, each of the second gate electrodes extending in the first direction, landing pads on the contact plugs, respectively; and capacitors on the landing pads, respectively.

The semiconductor device in accordance with some example embodiments may include the first and second gate electrodes, the bit line structure, and the first and second insulation patterns disposed between the bit line structure and the first and second gate electrodes, thereby reducing or preventing electrical short and/or leakage current therebetween. Thus, the electrical short or leakage current may be effectively reduced or prevented so that the semiconductor device may have improved electrical characteristics.

At least some of the above and other features of the invention are set out in the claims.

### BRIEF DESCRIPTION OF THE DRAWINGS

FIGS. 1 to 3 are a plan view and cross-sectional views illustrating a semiconductor device in accordance with an example embodiment.
FIGS. 4 to 33 are plan views and cross-sectional views illustrating a method of manufacturing a semiconductor device in accordance with an example embodiment.

### DETAILED DESCRIPTION

The above and other aspects and features of a semiconductor device and a method of forming the same in accordance with example embodiments will become readily understood from detail descriptions that follow, with reference to the accompanying drawings. It will be understood that, although the terms "first," "second," and/or "third" may be used herein to describe various materials, layers (films), regions, electrodes, pads, patterns, structures and processes, these materials, layers (films), regions, electrodes, pads, patterns, structures and processes should not be limited by these terms. These terms are only used to distinguish one material, layer (film), region, electrode, pad, pattern, structure and process from another material, layer (film), region, electrode, pad, pattern, structure and process. Thus, a first material, layer (film), region, electrode, pad, pattern, structure and process discussed below could be termed a second or third material, layer (film), region, electrode, pad, pattern, structure and process without departing from the teachings of inventive concepts.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Parameters and/or ends of ranges that are quoted as being "about" a certain value (e.g. "about X") may also be considered equal to that value (e.g. "equal to X"). Nevertheless, any values quoted herein may include variations of that value within commonly accepted errors, margins and/or tolerances (e.g. manufacturing tolerances). For instance, any values quoted herein may also cover variations within ±5% or ±10%. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

As used herein, expressions such as "one of," "one or more of," "any one of," "at least one of," and "at least one selected from" when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

Hereinafter, in the specification (and not necessarily in the claims), two directions that are substantially perpendicular to each other among horizontal directions, which are substantially parallel to an upper surface of a substrate, may be referred to as first and second directions D1 and D2, respectively, and a vertical direction substantially perpendicular to the upper surface of the substrate may be referred to as a third direction D3. In some example embodiments, the first and second directions D1 and D2 may be orthogonal to each other. The third direction D3 may define a height direction (e.g., a vertical direction). For instance, upper surfaces may be located further along the third direction D3 than lower surfaces. Similarly, features that are described as above other features may be located further along the third direction D3 than the other features. It will be appreciated that the directions, positions and orientations described herein are described relative to the structure of the device, and need not imply any particular orientation of the device in use.

Each of the first to third directions D1, D2 and D3 may include not only a direction shown in the drawings but also a direction reverse thereto.

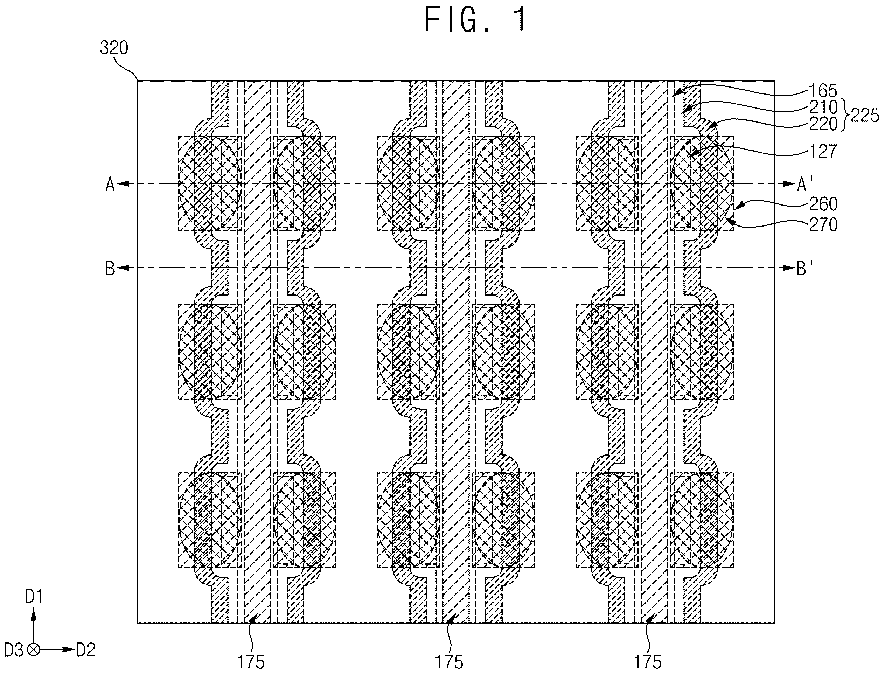

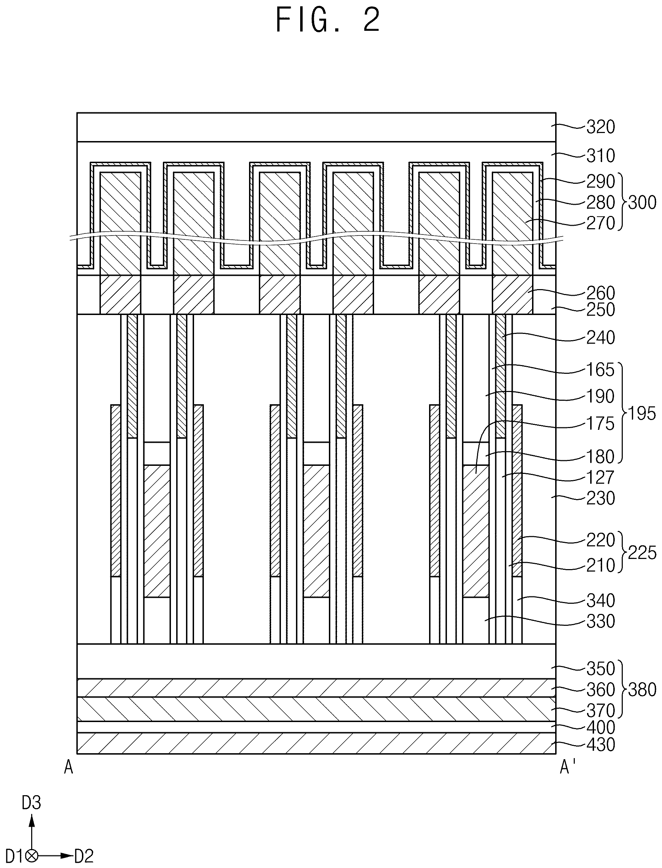

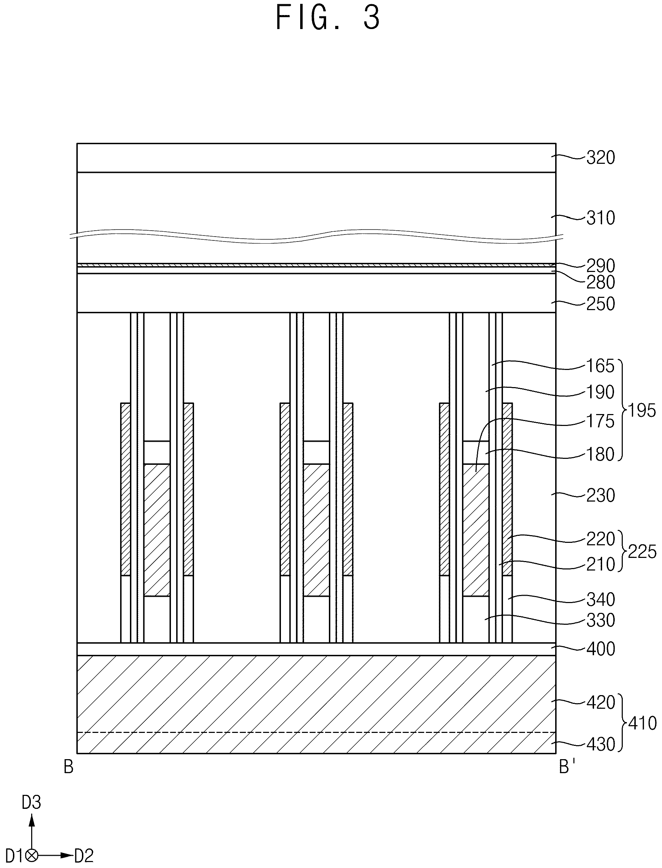

FIGS. 1 to 3 are a plan view and cross-sectional views illustrating a semiconductor device in accordance with an example embodiment. Particularly, FIG. 1 is the plan view, FIG. 2 is a cross-sectional view taken along line A-A' of FIG. 1, and FIG. 3 is a cross-sectional view taken along line B-B' of FIG. 1.

Referring to FIGS. 1 to 3, the semiconductor device may include a bit line shield structure 410, a bit line structure 380, first and second gate structures 195 and 225, a channel 127, a gate division pattern 230, a landing pad 260 and a capacitor structure. The semiconductor device may be a dynamic random access memory (DRAM) device.

The semiconductor device may further include first and second insulating interlayers 250 and 320, first and second insulation patterns 330 and 340 and a contact plug 240.

The bit line shield structure 410 may include a bit line shield plate 430 and a bit line shield fin 420 that are stacked in the third direction D3 and contact each other. In some example embodiments, the bit line shield plate 430 may have a shape of a flat plane. The bit line shield fin 420 may protrude from the bit line shield plate 430 in the third direction D3, and may extend in the second direction D2. In some example embodiments, a plurality of bit line shield fins 420 may be spaced apart from each other in the first direction D1.

In some example embodiments, the bit line shield plate 430 and the bit line shield fin 420 may be integrally formed. That is, the bit line shield plate 430 and the bit line shield fin 420 may include the same or substantially similar material and may contact each other, so as not to be distinguished from each other. Each of the bit line shield plate 430 and the bit line shield fin 420 may include a conductive material (e.g., metal, metal nitride, metal silicide, etc.).

The third insulation pattern 400 may cover an upper surface of the bit line shield structure 410. The third insulation pattern 400 may include an oxide (e.g., silicon oxide).

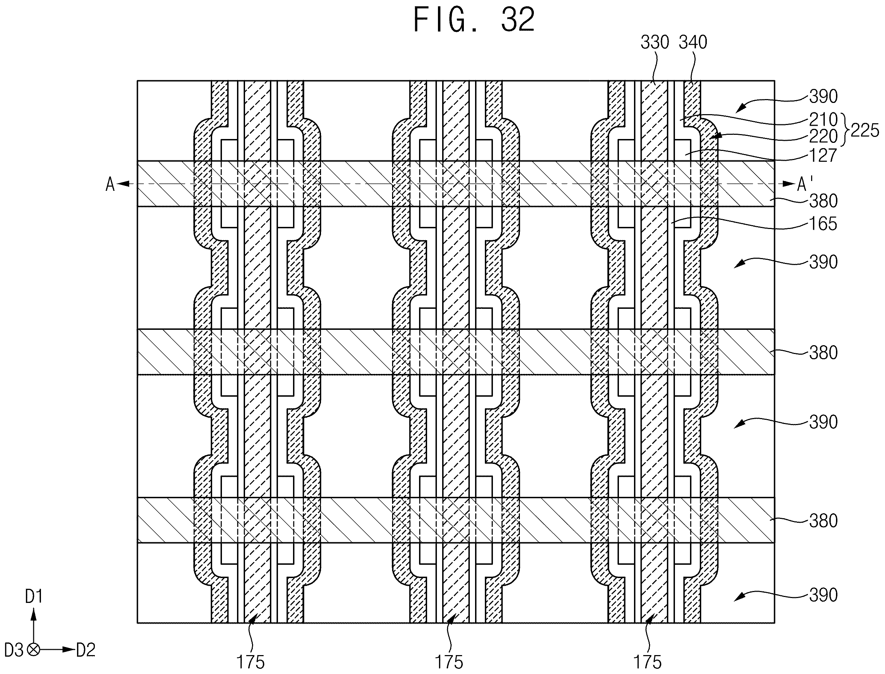

The bit line structure 380 may be disposed on the third insulation pattern 400. Referring to FIGS. 1 to 3 together with FIG. 32, the bit line structure 380 may extend in the second direction D2, and a plurality of bit line structures 380 may be spaced apart from each other in the first direction D1. Each of the bit line structures 380 may be disposed between neighboring ones (e.g., a corresponding adjacent pair) of the bit line shield fins 420 in the first direction D1, and a lower surface and a sidewall of each of the bit line structures 380 may be covered by the third insulation pattern 400. For instance, for each bit line structure 380, a lower surface and opposite sidewalls in the second direction D2 may be covered by the third insulation pattern 400.

In some example embodiments, the bit line structure 380 may include a second conductive pattern 370, a bit line barrier pattern 360 and a first conductive pattern 350 sequentially stacked in the third direction D3. The second conductive pattern 370 may include metal and/or metal nitride, the bit line barrier pattern 360 may include metal silicon nitride (e.g., titanium silicon nitride), and the first conductive pattern 350 may include, for example, doped polysilicon.

The first gate structure 195 may extend in the first direction D1 on the bit line structure 380 and the third insulation pattern 400, and a plurality of first gate structures 195 may be spaced apart from each other in the second direction D2.

The first gate structure 195 may include a first gate electrode 175, a gate barrier pattern 180 and a capping pattern 190 sequentially stacked in the third direction D3, and a first gate insulation pattern 165 covering each of opposite sidewalls in the second direction D2 of each of the first gate electrode 175, the gate barrier pattern 180 and the capping pattern 190. The first gate electrode 175 may be disposed on the bit line structure 380 and the third insulation pattern 400, a lower surface of the gate barrier pattern 180 may contact an upper surface of the first gate electrode 175, and a lower surface of the capping pattern 190 may contact an upper surface of the gate barrier pattern 180. An upper surface of the first gate insulation pattern 165 may be coplanar with an upper surface of the capping pattern 190 and a lower surface of the first gate insulation pattern 165 may be coplanar with a lower surface of the first insulation pattern 330.

In some example embodiments, the gate barrier pattern 180 may have a thickness in the third direction D3 smaller than a thickness of the first gate electrode 175 disposed beneath the gate barrier pattern 180 and a thickness of the capping pattern 190 disposed on the gate barrier pattern 180. For instance, the thickness of the gate barrier pattern 180 may be smaller than each of the first gate electrode 175 and the capping pattern 190. The thickness of the gate barrier pattern 180 may be in a range of about 10Å to about 60Å.

In some example embodiments, a lower surface of the first gate insulation pattern 165 may contact an upper surface of the bit line structure 380 and an upper surface of the third insulation pattern 400, and an upper portion of an inner sidewall in the second direction D2 of the first gate insulation pattern 165 may contact sidewalls in the second direction D2 of the first gate electrode 175, the gate barrier pattern 180 and the capping pattern 190.

In some example embodiments, the first gate electrode 175 may include a conductive material (e.g., metal, metal nitride, metal silicide, etc.), the gate barrier pattern 180 may include an insulating nitride (e.g., silicon nitride), the capping pattern 190 may include an insulating material (e.g., silicon nitride, silicon oxide, etc.), and the first gate insulation pattern 165 may include an oxide (e.g., silicon oxide).

The first insulation pattern 330 may be disposed on the bit line structure 380 and the third insulation pattern 400, and may contact a lower portion of the inner sidewall in the second direction D2 of the first gate insulation pattern 165 and a lower surface of the first gate electrode 175. That is, the first gate electrode 175 may be spaced apart from the bit line structure 380 by the first insulation pattern 330.

In some example embodiments, the first insulation pattern 330 may include an insulating material (e.g., silicon oxide, silicon nitride, etc.).

A plurality of channels 127 may be spaced apart from each other in each of the first and second directions D1 and D2 on the bit line structure 380. In some example embodiments, a plurality of channels 127 may contact an upper surface of the first conductive pattern 350 included in each of the bit line structures 380, and may be spaced apart from each other in the second direction D2.

The channel 127 may also contact each of opposite outer sidewalls in the second direction D2 of the first gate insulation pattern 165. That is, the channel 127 may be formed of two portions that cover opposite outer sidewalls in the second direction D2 of the first gate insulation pattern 165. For instance, the channel 127 may be considered a pair of channels on opposite sides of the first gate electrode 175. In some example embodiments, an upper surface of the channel 127 may be higher than an upper surface of the gate barrier pattern 180.

In some example embodiments, the channel 127 may include a semiconductor material (e.g., silicon, germanium, silicon-germanium, etc.). In some example embodiments, the channel 127 may include an oxide semiconductor material. The oxide semiconductor material may include at least one of zinc tin oxide (ZTO), indium zinc oxide (IZO), zinc oxide (ZnOₓ), indium gallium zinc oxide (IGZO), indium gallium silicon oxide (IGSO), Indium oxide (InOₓ, In₂O₃), tin oxide (SnO₂), titanium oxide (TiOₓ), zinc oxide nitride (ZnₓOyN_{z}), magnesium zinc oxide (MgₓZn_{y}O_{z}), indium zinc oxide (InₓZn_{y}Oₐ), indium gallium zinc oxide (InₓGa_{y}Zn_{z}Oₐ), zirconium indium zinc oxide (ZrₓIn_{y}Zn_{z}Oₐ), hafnium indium zinc oxide (HfₓIn_{y}Zn_{z}Oₐ), tin indium zinc oxide (SnₓIn_{y}Zn_{z}Oₐ), aluminum tin indium zinc oxide (AlₓSn_{y}In_{z}ZnₐO_{d}), silicon indiumzinc oxide (SiₓIn_{y}Zn_{z}Oₐ), zinc tin oxide (ZnₓSn_{y}O_{z}), aluminum zinc tin oxide (AlₓZn_{y}Sn_{z}Oₐ), gallium zinc tin oxide (GaₓZn_{y}Sn_{z}Oₐ), zirconium zinc tin oxide (ZrₓZn_{y}Sn_{z}Oₐ) or indium gallium silicon oxide (InGaSiO).

The second gate structure 225 may extend in the first direction D1 on the bit line structure 380 and the third insulation pattern 400, and a plurality of second gate structures 225 may be spaced apart from each other in the second direction D2. In some example embodiments, the second gate structure 225 may include a second gate insulation pattern 210 and a second gate electrode 220 sequentially stacked on each of opposite sidewalls in the second direction D2 of the first gate structure 195, the channel 127 and the contact plug 240.

The second gate insulation pattern 210 may cover an outer sidewall in the second direction D2 and opposite sidewalls in the first direction D1 of the channel 127, and an outer sidewall in the second direction D2 of a portion of the first gate insulation pattern 165 not covered by the channel 127. The second gate electrode 220 may cover a lower portion of an outer sidewall in the second direction D2 of the second gate insulation pattern 210.

The second gate insulation pattern 210 may not extend in a straight line in the first direction D1, but may extend in a bent or curved manner in the first direction D1 in a plan view. That is, the second gate insulation pattern 210 may include a first portion contacting a sidewall of the channel 127, a second portion contacting a sidewall of the first gate insulation pattern 165, and a third portion that is disposed between the first and second portions and connects the first and second portions to each other. The first and second portions of the second gate insulation pattern 210 may not be aligned with each other in the first direction D1 due to the channel 127, and the first and second portions may be alternately and repeatedly disposed in the first direction D1 so that the second gate insulation pattern 210 may extend in the bent or curved manner in the first direction D1.

The second gate electrode 220 may not extend in a straight line in the first direction D1, but may extend in a bent or curved manner in the first direction D1 in a plan view. That is, the second gate electrode 220 may include a first portion contacting the first portion of the second gate insulation pattern 210, a second portion contacting the second portion of the second gate insulation pattern 210, and a third portion that is disposed between the first and second portions of the second gate electrode 220 and connects the first and second portions of the second gate electrode 220 to each other. The first and second portions of the second gate electrode 220 may not be aligned with each other in the first direction D1 due to the second gate insulation pattern 210, and the first and second portions may be alternately and repeatedly disposed in the first direction D1 so that the second gate electrode 220 may extend in the bent or curved manner in the first direction D1.

In some example embodiments, the second gate electrode 220 may include a conductive material (e.g., metal, metal nitride, metal silicide, etc.), and the second gate insulation pattern 210 may include an insulating material (e.g., silicon oxide, silicon nitride, etc.).

The second insulation pattern 340 may be disposed on the bit line structure 380 and the third insulation pattern 400, and may contact a lower portion of an outer sidewall in the second direction D2 of the second gate insulation pattern 210 and a lower surface of the second gate electrode 220. That is, the second gate electrode 220 may be spaced apart from the bit line structure 380 by the second insulation pattern 340.

FIGS. 2 and 3 show that an upper surface of the first insulation pattern 330, that is, a lower surface of the first gate electrode 175 is lower than an upper surface of the second insulation pattern 340, that is, a lower surface of the second gate electrode 220, however, the inventive concepts are not limited thereto. In some example embodiments, the upper surface of the first insulation pattern 330 may be higher than or substantially coplanar with the upper surface of the second insulation pattern 340.

In some example embodiments, the first insulation pattern 330 may include an insulating material (e.g., silicon oxide, silicon nitride, etc.).

The contact plug 240 may be disposed on the channel 127, and may contact an upper surface of the channel 127. In some example embodiments, the contact plug 240 may contact an upper portion of an outer sidewall in the second direction D2 of the first gate insulation pattern 165 and an upper portion of an inner sidewall in the second direction D2 of the second gate insulation pattern 210.

In some example embodiments, a plurality of contact plugs 240 may be spaced apart from each other in each of the first and second directions D1 and D2, and may be arranged in a lattice pattern or a honeycomb pattern in a plan view.

In some example embodiments, the contact plug 240 may include polysilicon or a conductive material (e.g., metal, metal nitride, metal silicide, etc.). In some example embodiments, the contact plug 240 may have a double-layered structure including an undoped polysilicon layer and a doped polysilicon layer.

The gate division pattern 230 may be disposed on the bit line structure 380 and the third insulation pattern 400, and may contact upper surfaces of the bit line structure 380 and the third insulation pattern 400.

In some example embodiments, the gate division pattern 230 may include a lower portion contacting an outer sidewall in the second direction D2 of the second gate electrode 220 and an outer sidewall in the second direction D2 of the second insulation pattern 340, and an upper portion disposed on the lower portion and contacting an upper portion of an outer sidewall in the second direction D2 of the second gate insulation pattern 210 and an upper surface of the second gate electrode 220. In some example embodiments, the upper portion of the gate division pattern 230 may have a width greater than a width of the lower portion of the gate division pattern 230.

In some example embodiments, the gate division pattern 230 may extend in the first direction D1, and a plurality of gate division patterns 230 may be spaced apart from each other in the second direction D2. The gate division pattern 230 may be disposed between neighboring ones (e.g., a corresponding adjacent pair) of the second gate structures 225 in the second direction D2.

In some example embodiments, the gate division pattern 230 may include an insulating material, for example, an oxide such as silicon oxide, a nitride such as silicon nitride, etc.

The landing pad 260 may extend through the first insulating interlayer 250, and may contact an upper surface of the contact plug 240. In some example embodiments, a plurality of landing pads 260 may be spaced apart from each other in each of the first and second directions D1 and D2 corresponding to the plurality of contact plugs 240, respectively, and may be arranged in a lattice pattern or a honeycomb pattern in a plan view. FIG. 1 shows that the landing pad 260 has a shape of a rectangle in a plan view, however, the inventive concepts are not limited thereto, and may have other shapes, for example, a circle, an ellipse, a rectangle with rounded corners, etc. The landing pad 260 may include a conductive material (e.g., metal, metal nitride, metal silicide, doped polysilicon, etc.).

The capacitor structure may include a capacitor 300 and an upper plate electrode 310. The capacitor 300 may include a first capacitor electrode 270, a dielectric pattern 280 and a second capacitor electrode 290.

In some example embodiments, a plurality of first capacitor electrodes 270 may be spaced apart from each other in each of the first and second directions D1 and D2, and may contact corresponding ones, respectively, of the plurality of landing pads 260. The dielectric pattern 280 may be disposed on upper surfaces and sidewalls of the first capacitor electrodes 270 and an upper surface of the first insulating interlayer 250. The second capacitor electrode 290 may be disposed on the dielectric pattern 280.

The first capacitor electrode 270 may include, for example, metal, metal nitride, metal silicide, etc., the dielectric pattern 280 may include, for example, metal oxide, and the second capacitor electrode 290 may include, for example, metal, metal nitride, metal silicide, doped silicon-germanium, etc.

The upper plate electrode 310 may be disposed on the second capacitor electrode 290, and may include, for example, doped silicon-germanium.

The second insulating interlayer 320 may be disposed on the first insulating interlayer 250, and may cover the upper plate electrode 310.

Each of the first and second insulating interlayers 250 and 320 may include an insulating material (e.g., silicon oxide, silicon nitride, a low-k dielectric material, etc.). A low-k dielectric material may be a material having a dielectric constant (k) that is lower than that of silicon oxide.

In the semiconductor device, current may flow through the channel 127 extending in the third direction D3, that is, in the vertical direction between the bit line structure 380 and the landing pad 260, and thus the semiconductor device may include a vertical channel transistor (VCT) having a vertical channel. The second gate electrode 220 may serve as a front gate electrode or a word line, and the first gate electrode 175 may serve as a back gate electrode.

The first gate structure 195 in the semiconductor device may include the gate barrier pattern 180 between the first gate electrode 175 and the capping pattern 190. The semiconductor device may further include the first and second insulation patterns 330 and 340 that may be disposed between the first and second gate electrodes 175 and 220 and the bit line structure 380, respectively, and may reduce or prevent an electrical short and/or a leakage current therebetween.

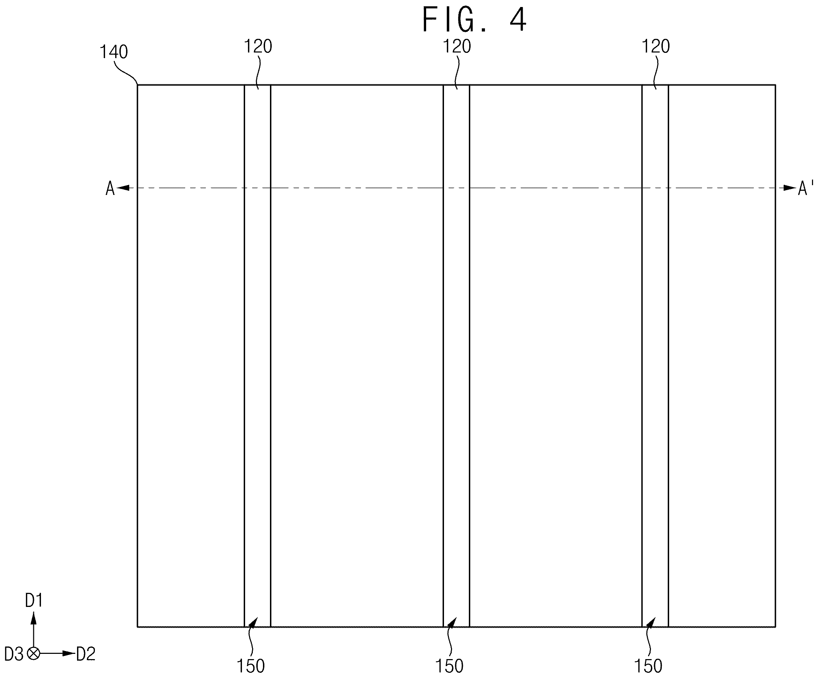

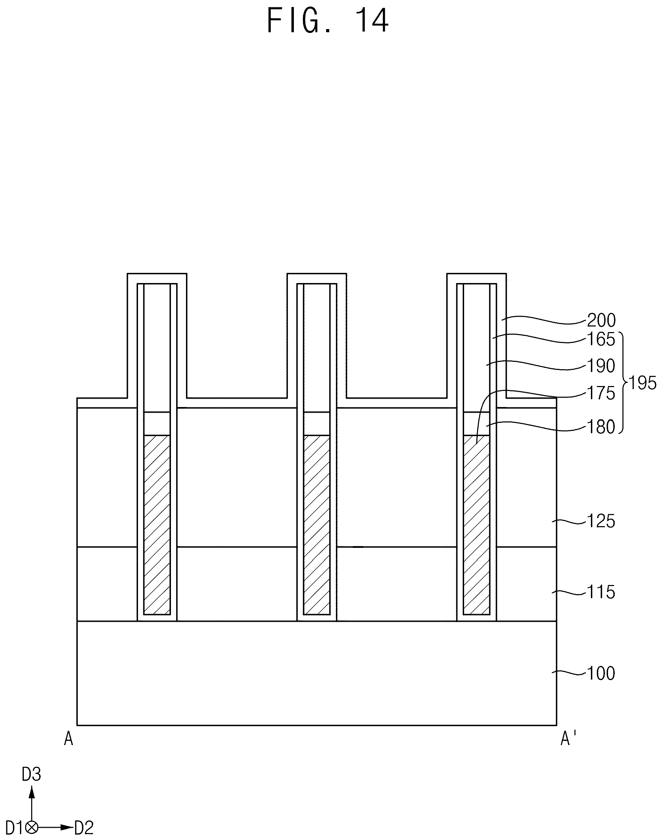

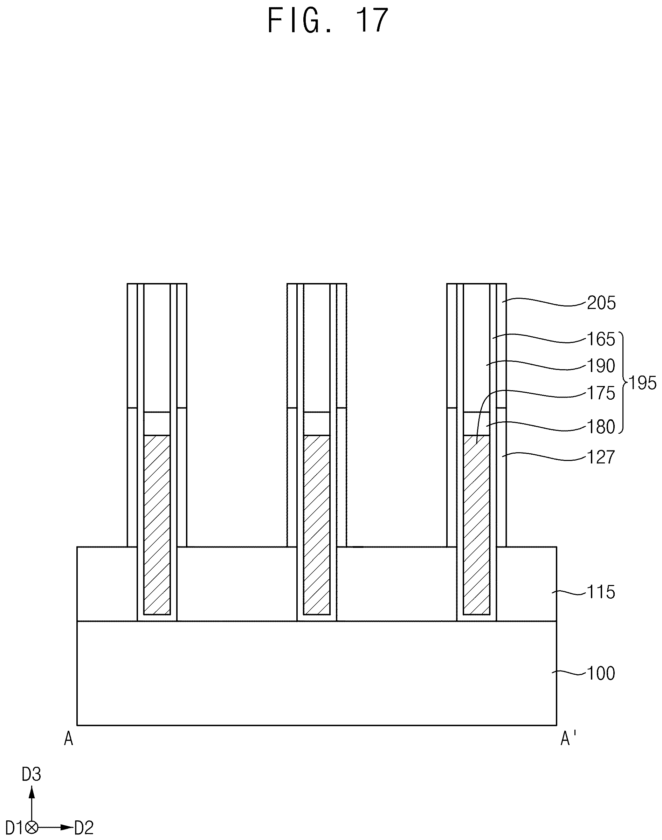

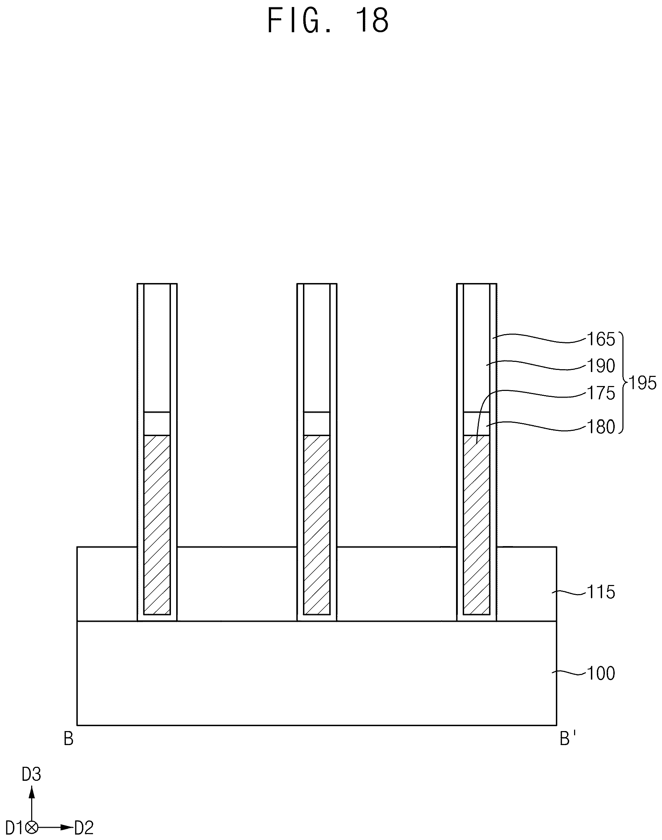

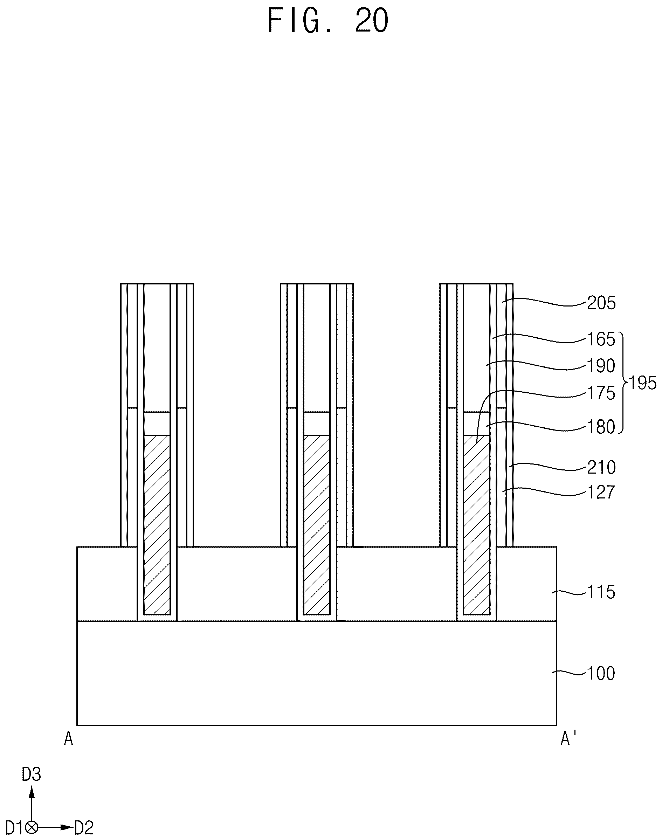

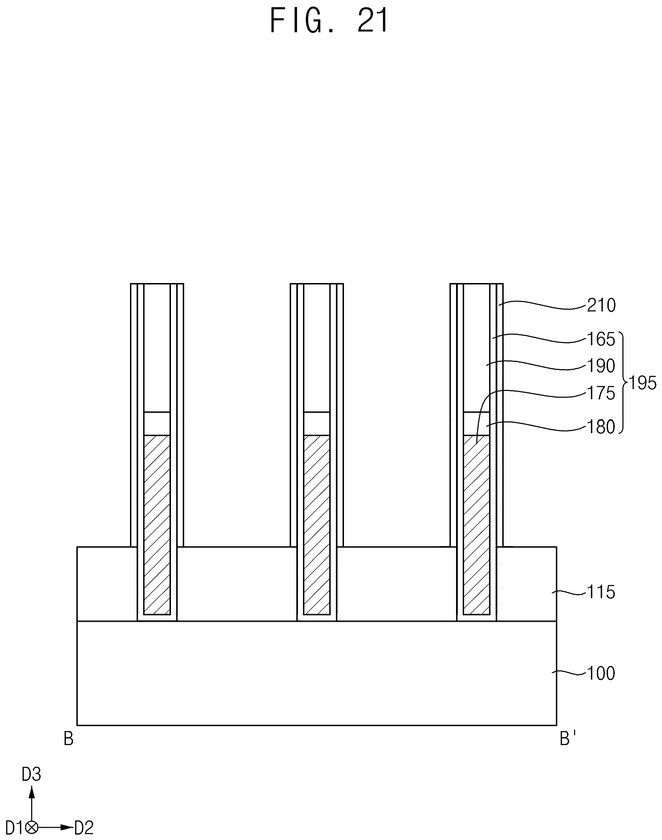

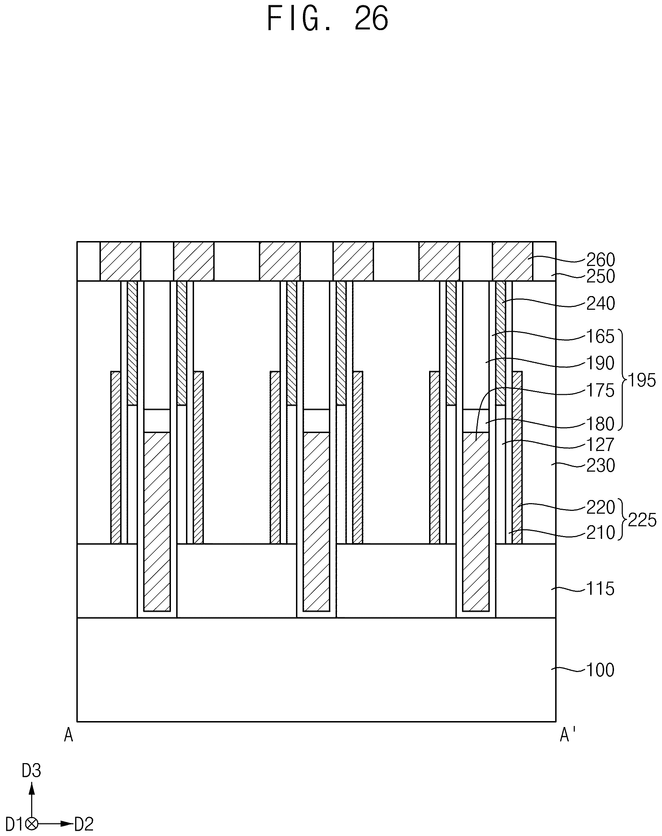

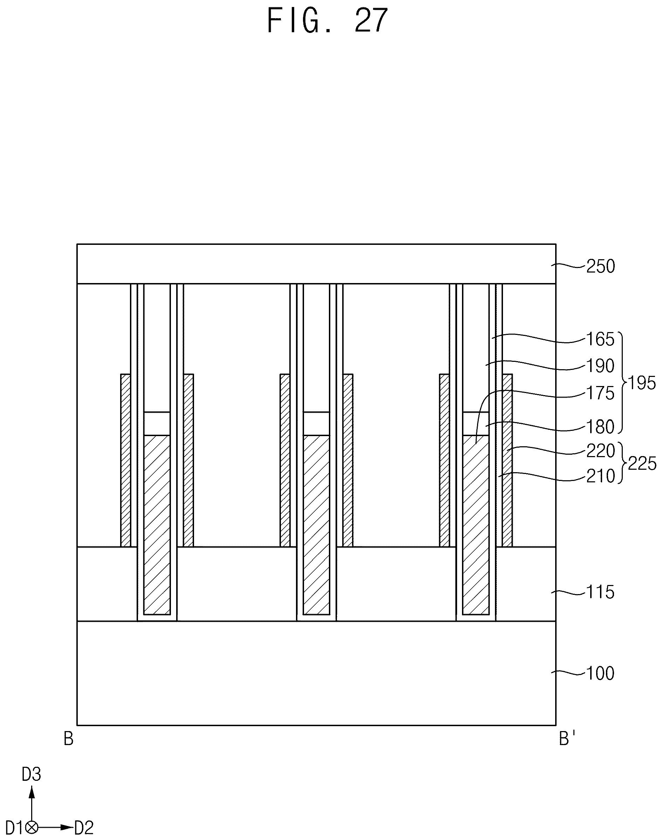

As illustrated below with reference to FIGS. 4 to 33, the gate barrier pattern 180 may reduce or prevent excess oxygen included in the capping pattern 190 from diffusing into the first gate electrode 175. Thus, a recess that may be formed by partially removing the first gate electrode 175 may have a sufficiently large depth, and the first insulation pattern 330 that may be formed in the recess may have a sufficiently large thickness. Accordingly, the first insulation pattern 330 may effectively reduce or prevent the electrical short and/or leakage current between the first gate electrode 175 and the bit line structure 380 so that the semiconductor device may have improved electrical characteristics.

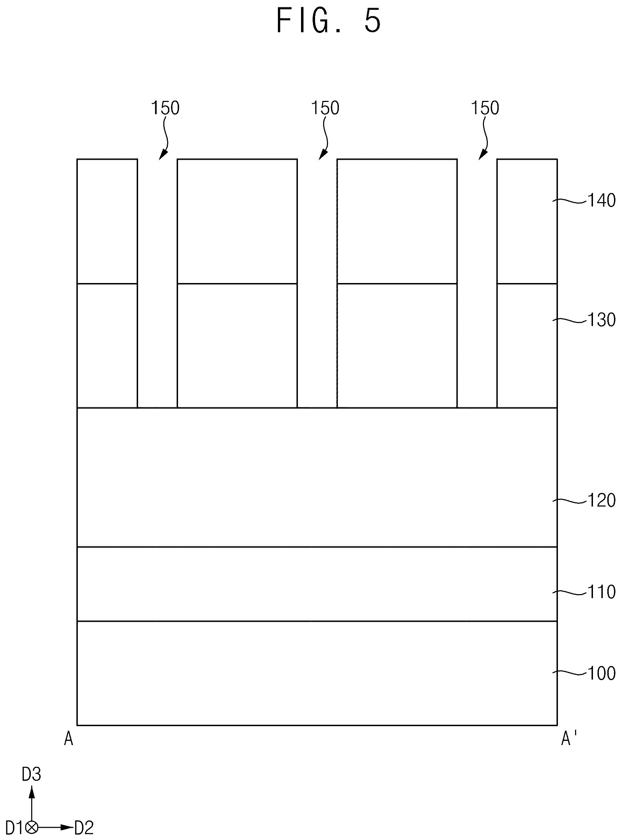

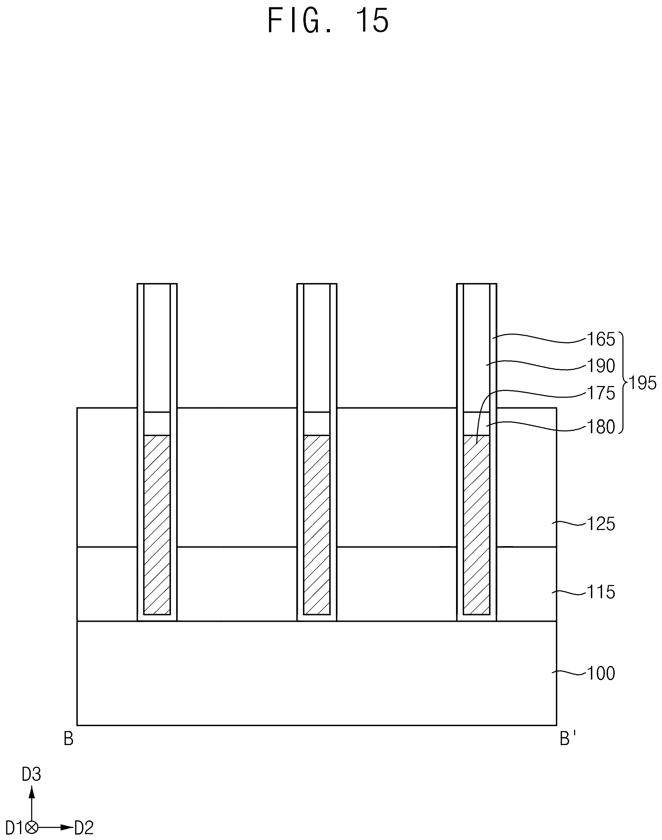

FIGS. 4 to 33 are plan views and cross-sectional views illustrating a method of manufacturing a semiconductor device in accordance with an example embodiment. FIGS. 4, 8, 10, 13, 16, 19, 22, 25, 28 and 32 are the plan views, FIGS. 5, 6, 7, 9, 11, 12, 14, 17, 20, 23, 26, 29, 30, 31 and 33 are cross-sectional views taken along lines A-A' of corresponding plan views, respectively, and FIGS. 15, 18, 21, 24 and 27 are cross-sectional views taken along lines B-B' of corresponding plan views, respectively.

Referring to FIGS. 4 and 5, first and second mask layers may be formed on a substrate, a first etching mask extending in the first direction D1 may be formed on the second mask layer, and an etching process may be performed using the first etching mask to partially remove the first and second mask layers.

Thus, a first opening 150 may be formed to expose an upper surface of the substrate, and the first and second mask layers may be transformed into first and second mask patterns 130 and 140, respectively.

The substrate may be, for example, a silicon-on-insulator (SOI) substrate or a germanium-on-insulator (GOI) substrate, and thus may include a first bulk substrate 100, a buried insulation layer 110 and a second bulk substrate 120 sequentially stacked in the third direction D3. Each of the first and second bulk substrates 100 and 120 may include a semiconductor material (e.g., silicon, germanium, etc.), and the buried insulation layer 110 may include, for example, an oxide (e.g., an oxide of the semiconductor material (e.g., silicon oxide, germanium oxide, etc.)).

The first mask pattern 130 may include a material having an etch selectivity with respect to the second bulk substrate 120, for example, silicon nitride, and the second mask pattern 140 may include, for example, spin-on-hardmask (SOH), silicon oxynitride, etc.

In some example embodiments, the first opening 150 may extend in the first direction D1, and a plurality of first openings 150 may be formed to be spaced apart from each other in the second direction D2.

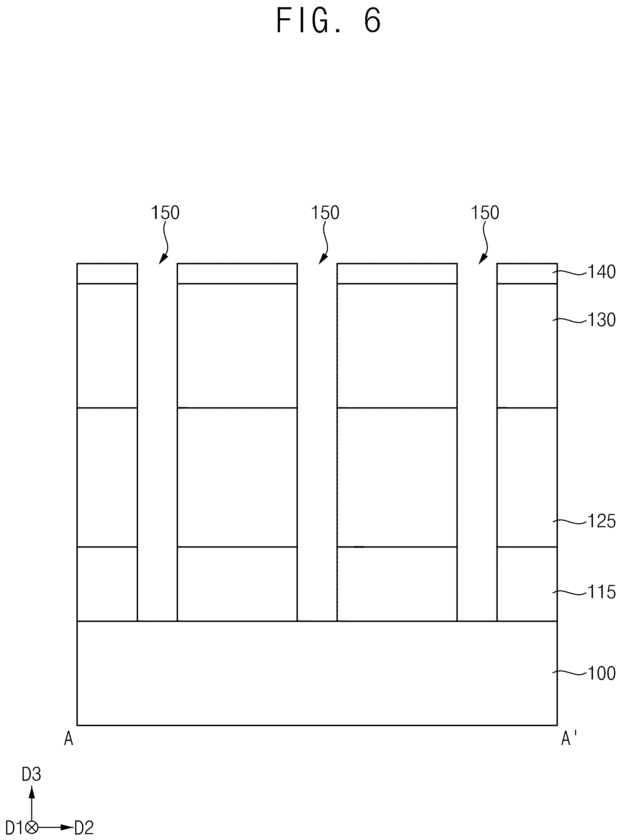

Referring to FIG. 6, an etching process may be performed using the first and second mask patterns 130 and 140 as an etching mask to partially remove the second bulk substrate 120 and the buried insulation layer 110.

Thus, the first opening 150 may be enlarged downwardly in the third direction D3 to expose an upper surface of the first bulk substrate 100, and the second bulk substrate 120 and the buried insulation layer 110 may be transformed into a preliminary channel pattern 125 and a buried insulation pattern 115, respectively.

In some example embodiments, each of the preliminary channel pattern 125 and the buried insulation pattern 115 may extend in the first direction D1, and a plurality of preliminary channel patterns 125 may be spaced apart from each other in the second direction D2 and a plurality of buried insulation patterns 115 may be spaced apart from each other in the second direction D2.

A portion of the second mask pattern 140 and the first mask pattern 130 may remain on the preliminary channel pattern 125 after the etching process.

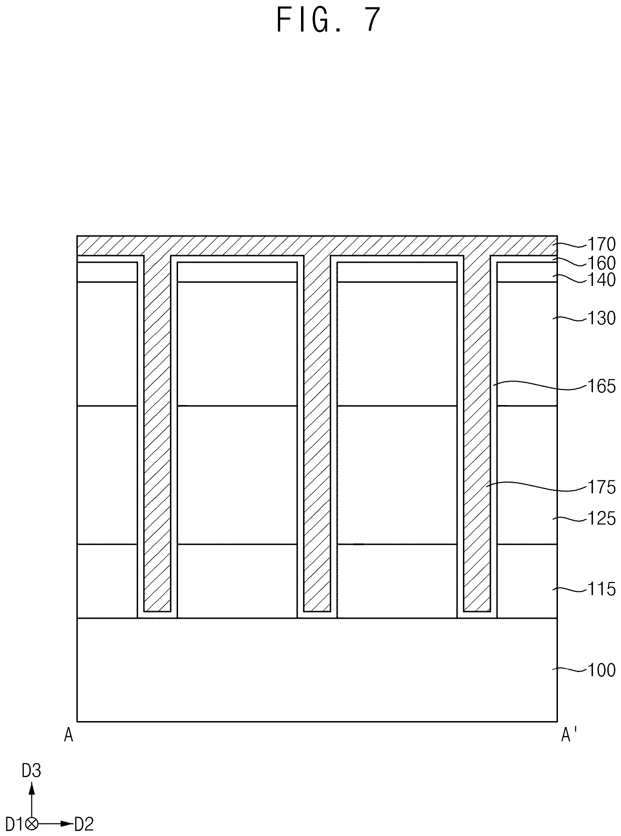

Referring to FIG. 7, a first gate insulation layer 160 may be formed on an upper surface of the first bulk substrate 100, sidewalls of the buried insulation pattern 115, the preliminary channel pattern 125 and the first mask pattern 130, and an upper surface and a sidewall of the second mask pattern 140, and a first gate electrode layer 170 may be formed on the first gate insulation layer 160 to fill the first opening 150.

In some example embodiments, the first gate insulation layer 160 may be formed by an atomic layer deposition (ALD) process, and may include an oxide (e.g., silicon oxide). The first gate electrode layer 170 may include a first conductive material (e.g., titanium nitride).

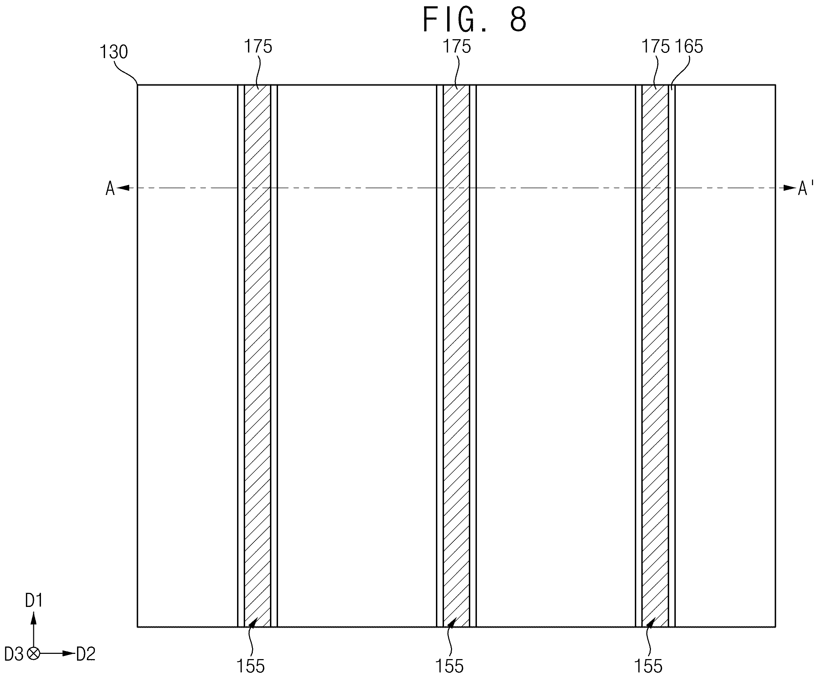

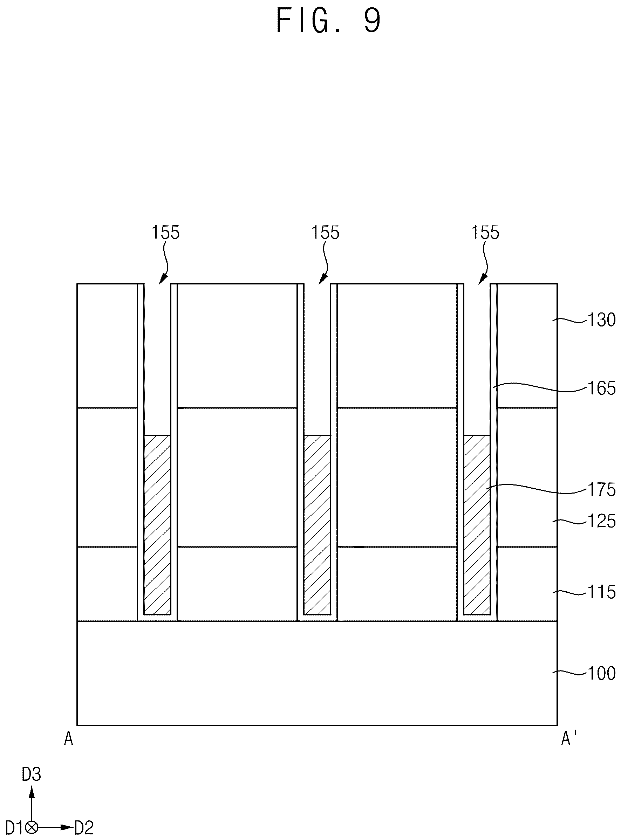

Referring to FIGS. 8 and 9, a planarization process (e.g., a chemical mechanical polishing (CMP) process) may be performed on the first gate electrode layer 170 and the first gate insulation layer 160 until an upper surface of the second mask pattern 140 is exposed, and an upper portion of the first gate electrode layer 170 may be removed by an etching process.

Thus, the first gate insulation layer 160 and the first gate electrode layer 170 may be transformed into a first gate insulation pattern 165 and a first gate electrode 175, respectively, and a trench 155 may be formed to expose an upper portion of an inner sidewall of the first gate insulation pattern 165 and an upper surface of the first gate electrode 175.

After the etching process, the upper surface of the first gate electrode 175 may be lower than an upper surface of the preliminary channel pattern 125.

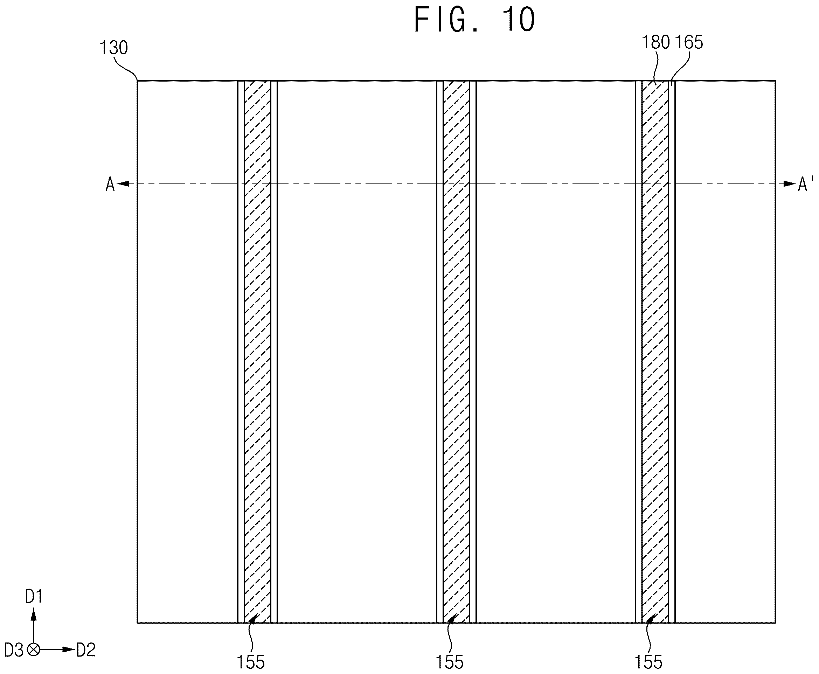

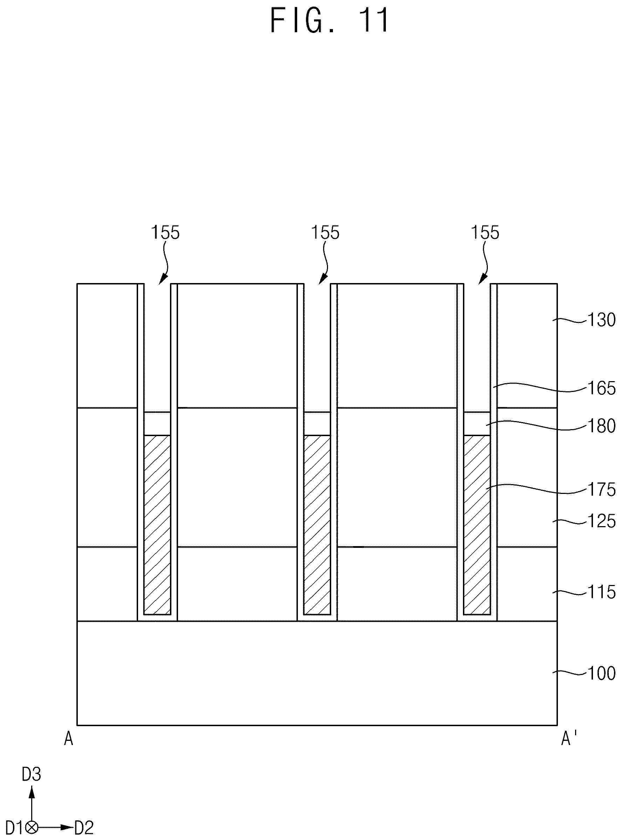

Referring to FIGS. 10 and 11, a gate barrier pattern 180 may be formed on the first gate electrode 175 to fill a lower portion of the trench 155.

For example, an area selective deposition (ASD) process using a deposition selectivity between the first conductive material and an oxide material (e.g., the material of the first gate insulation pattern 165) may be performed so that the gate barrier pattern 180 may be selectively deposited on the upper surface of the first gate electrode 175. When a thickness in the third direction D3 of the gate barrier pattern 180 is equal to or less than about 20Å, the gate barrier pattern 180 may not be formed on an inner sidewall of the first gate insulation pattern 165 due to the deposition selectivity.

On the other hand, when the thickness in the third direction D3 of the gate barrier pattern 180 is equal to or more than about 30Å, the gate barrier pattern 180 may also be formed on the inner sidewall of the first gate insulation pattern 165. In order to reduce or prevent the gate barrier pattern 180 from being deposited on the inner sidewall of the first gate insulation pattern 165, before performing the ASD process, a deposition prevention layer including (e.g., hexamethyldisilazane (HMDS)) may be formed. For instance, hexamethyldisilazane may be used to chemically passivate a surface of the first gate insulation pattern 165. The deposition prevention layer may reduce or prevent the gate barrier pattern 180 from being deposited on the first gate insulation pattern 165, the gate barrier pattern 180 may be formed only on the upper surface of the first gate electrode 175. A cleansing process, e.g., a plasma treatment process or an ashing process may be performed to remove the deposition prevention layer.

In some example embodiments, the gate barrier pattern 180 may include an insulating nitride (e.g., silicon nitride).

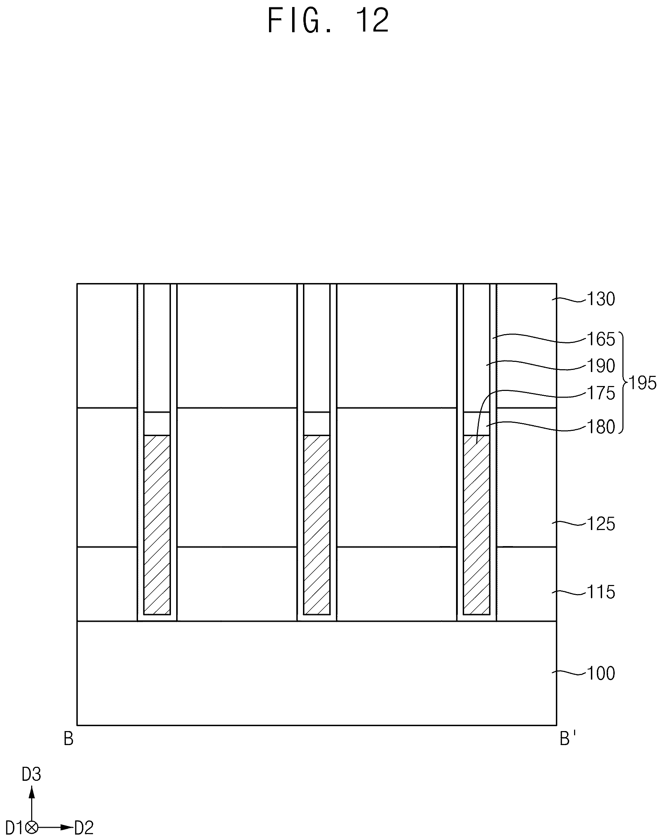

Referring to FIG. 12, a first insulation layer may be formed on an upper surface of the gate barrier pattern 180, and an upper surface and the inner sidewall of the first gate insulation pattern 165 and an upper surface of the first mask pattern 130, and a planarization process may be performed on the first insulation layer until the upper surface of the first mask pattern 130 is exposed to form a capping pattern 190 in an upper portion of the trench 155.

In some example embodiments, the capping pattern 190 may be formed by a chemical vapor deposition (CVD) process using a silicon source gas (e.g., silane (SiH₄)) and an oxidizing agent including oxygen, and thus may be formed to include silicon oxide. According to an amount of the oxidizing agent used in the CVD process, the capping pattern 190 may include excess oxygen.

The first gate electrode 175, the gate barrier pattern 180, the capping pattern 190 and the first gate insulation pattern 165 may collectively form a first gate structure 195. In some example embodiments, the first gate structure 195 may extend in the first direction D1, and a plurality of first gate structures 195 may be spaced apart from each other in the second direction D2.

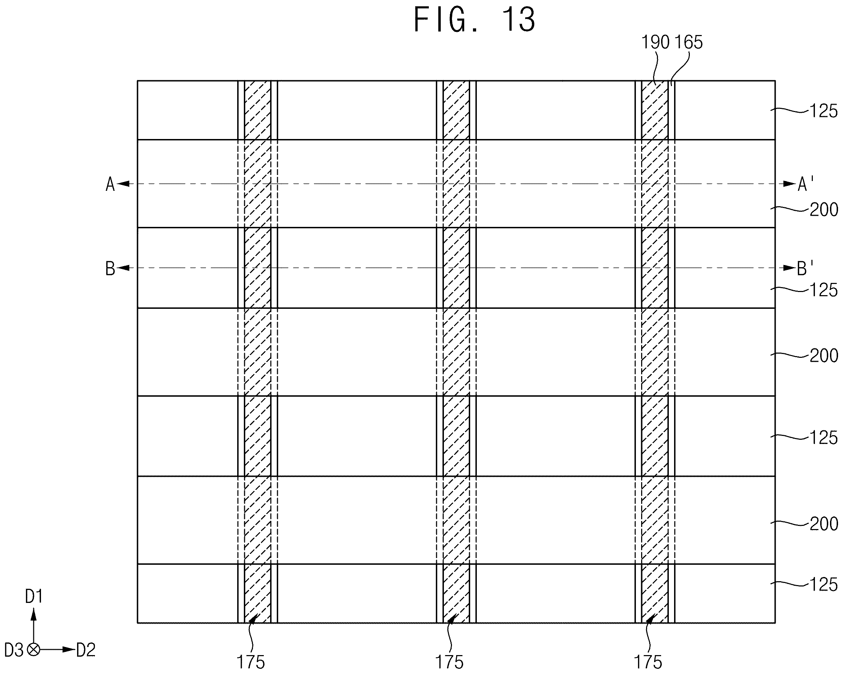

Referring to FIGS. 13 to 15, the first mask pattern 130 may be removed to expose the upper surface of the preliminary channel pattern 125, an upper surface and an upper portion of an outer sidewall of the first gate insulation pattern 165 and an upper surface of the capping pattern 190, and a third mask pattern 200 may be conformally formed to partially cover the exposed the upper surface of the preliminary channel pattern 125, the upper surface and the upper portion of the outer sidewall of the first gate insulation pattern 165 and the upper surface of the capping pattern 190.

In some example embodiments, the third mask pattern 200 may extend in the second direction D2, and a plurality of third mask patterns 200 may be spaced apart from each other in the first direction D1. The third mask pattern 200 may include, for example, silicon oxide or silicon nitride.

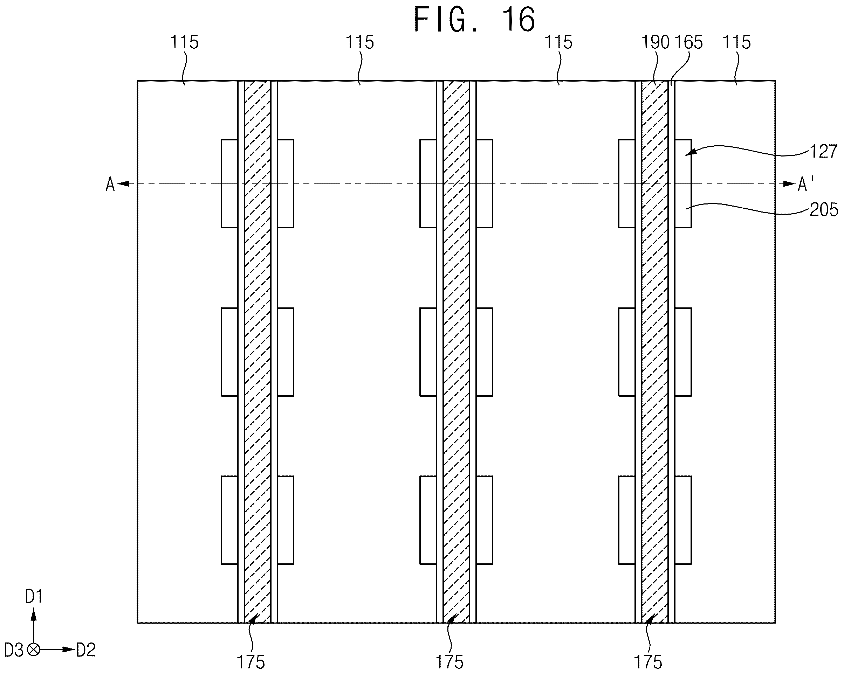

Referring to FIGS. 16 to 18, a plurality of channels 127 may be formed on the first bulk substrate 100 to be spaced apart from each other in the first direction D1 along the outer sidewall of the first gate insulation pattern 165.

For example, a first anisotropic etching process may be performed on the third mask pattern 200 to form a first spacer 205 on the upper portion of the outer sidewall of the first gate insulation pattern 165 and a portion of the upper surface of the preliminary channel pattern 125, and a second anisotropic etching process may be performed on the preliminary channel pattern 125 using the first spacer 205 as an etching mask. Thus, the preliminary channel pattern 125 may be transformed into the channel 127 covering each of opposite sidewalls in the second direction D2 of the first gate insulation pattern 165.

As the plurality of first mask patterns 130 are spaced apart from each other in the first direction D1 on the first bulk substrate 100, the plurality of channels 127 may be formed to be spaced apart from each other in the first direction D1.

By the second anisotropic etching process, a portion of the preliminary channel pattern 125 not covered by the first mask pattern 130 may be removed to expose a portion of the first gate insulation pattern 165.

Hereinafter, the first gate electrode 175, the gate barrier pattern 180, the capping pattern 190, the first gate insulation pattern 165, and the channels 127 and the first spacer 205 on each of opposite sidewalls in the second direction D2 of the first gate insulation pattern 165 may be collectively referred to as an extension structure.

In some example embodiments, the extension structure may extend in the first direction D1, and a plurality of extension structures may be spaced apart from each other in the second direction D2. Each extension structure may be symmetrical about an axis of symmetry extending in the first direction D1 down the center of the extension structure.

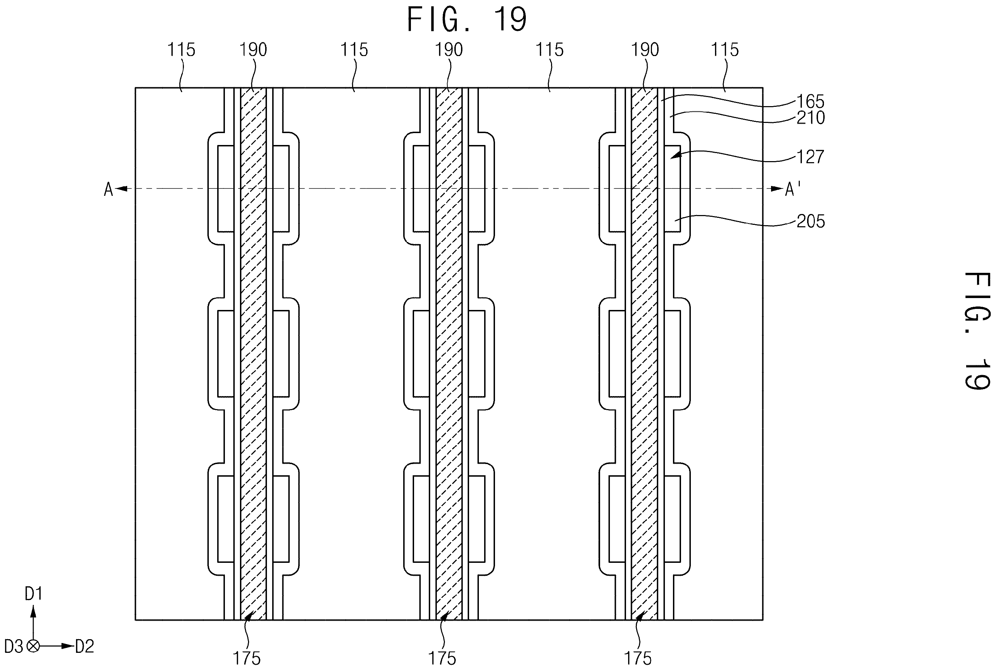

Referring to FIGS. 19 to 21, a second gate insulation pattern 210 may be formed on an outer sidewall of the extension structure.

In some example embodiments, the second gate insulation pattern 210 may be formed by forming a second gate insulation layer on an upper surface of the buried insulation pattern 115 and an upper surface and the outer sidewall of the extension structure, and performing an anisotropic etching process on the second gate insulation layer.

In some example embodiments, the second gate insulation pattern 210 may extend in the first direction D1 on each of opposite sidewalls in the second direction D2 of the extension structure, and a plurality of second gate insulation patterns 210 may be spaced apart from each other in the second direction D2.

A first heat treatment process may be performed on the second gate insulation pattern 210. In some example embodiments, the first heat treatment process may be performed at a temperature equal to or higher than about 800°C under an atmosphere of an inactive gas (e.g., argon gas).

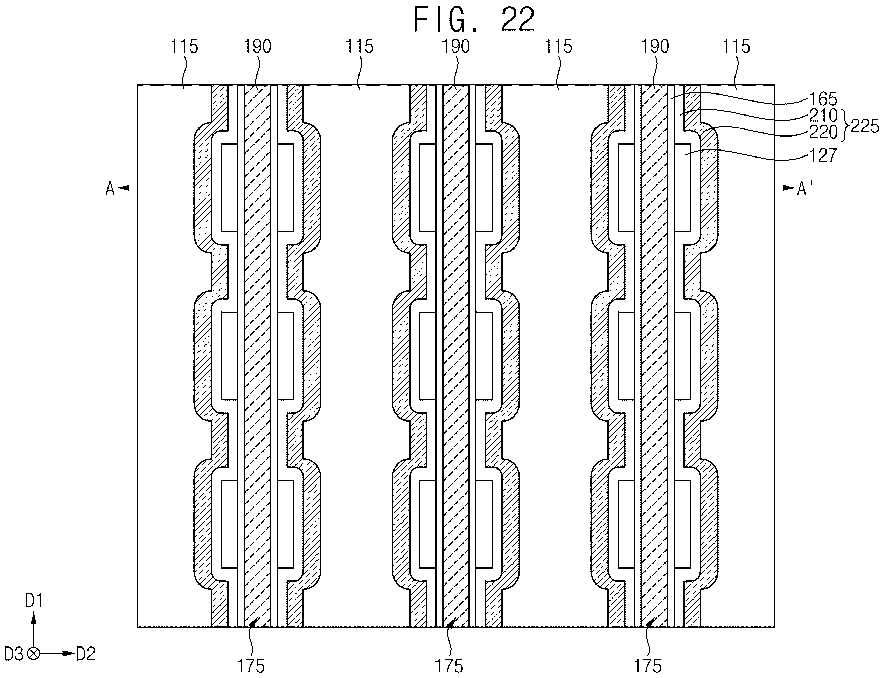

Referring to FIGS. 22 to 24, a second gate electrode 220 may be formed on an outer sidewall of the second gate insulation pattern 210.

In some example embodiments, the second gate electrode 220 may be formed by conformally forming a second gate insulation layer on the upper surface of the buried insulation pattern 115, the upper surface of the extension structure, and an upper surface and the outer sidewall of second gate insulation pattern 210, and performing an anisotropic etching process on the second gate insulation layer.

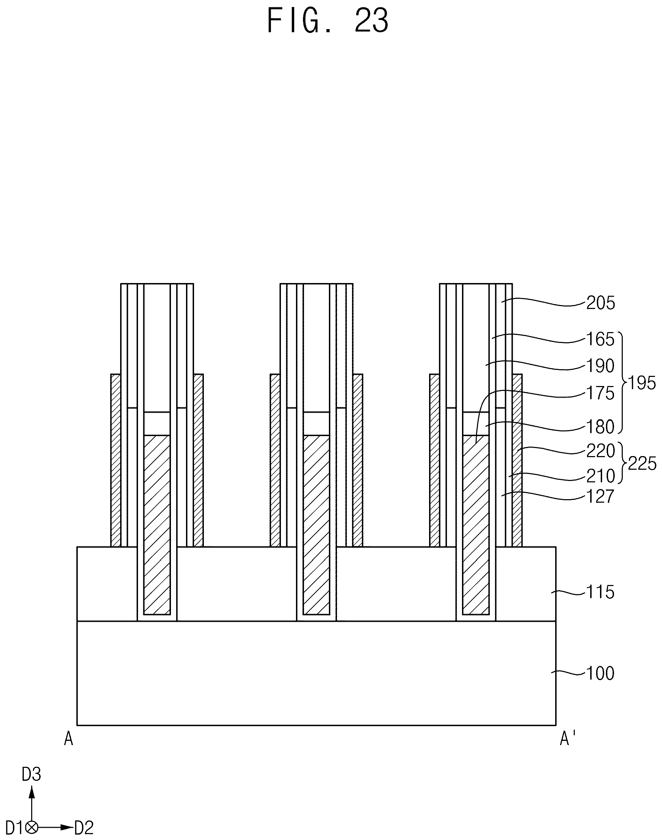

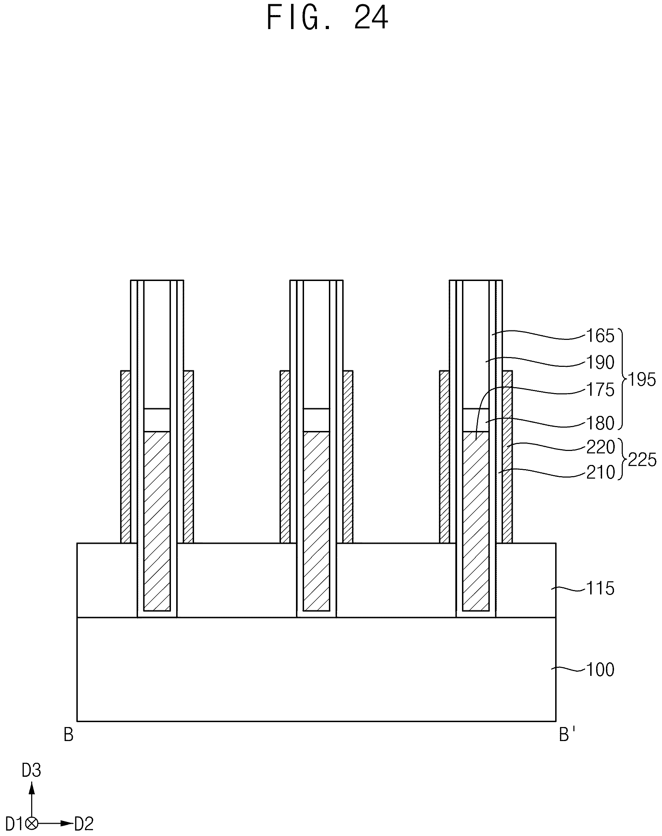

In some example embodiments, an upper surface of the second gate electrode 220 may be lower than the upper surface of the second gate insulation pattern 210. FIGS. 23 and 24 show that the upper surface of the second gate electrode 220 is substantially parallel to the upper surface of the first bulk substrate 100, however, the inventive concepts are not limited thereto. For example, the upper surface of the second gate electrode 220 may gradually become higher as it gets closer to the second gate insulation pattern 210.

The second gate electrode 220 and the second gate insulation pattern 210 may collectively form a second gate structure 225.

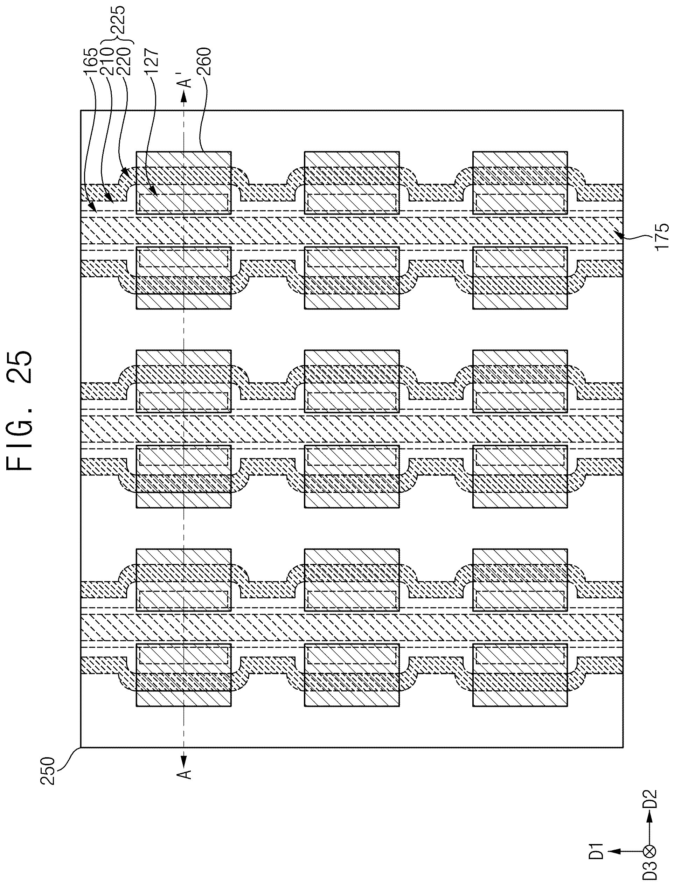

Referring to FIGS. 25 to 27, a gate division layer may be formed on the extension structure, the second gate structure 225 and the buried insulation pattern 115, and a planarization process may be performed on the gate division layer until the upper surfaces of the capping pattern 190, the first gate insulation pattern 165, the first spacer 205 and the second gate insulation pattern 210 are exposed to form a gate division pattern 230.

The first spacer 205 may be removed to form a second opening to expose an upper surface of the channel 127, and a contact plug 240 may be formed to fill the second opening.

In some example embodiments, a plurality of contact plugs 240 may be formed to be spaced apart from each other in each of the first and second directions D1 and D2, and may contact the channels 127, respectively.

A first insulating interlayer 250 may be formed on the gate division pattern 230, the second gate insulation pattern 210, the contact plug 240, the first gate insulation pattern 165 and the capping pattern 190, and a landing pad 260 may be formed through the first insulating interlayer 250 to contact an upper surface of the contact plug 240.

In some example embodiments, a plurality of landing pads 260 may be formed to be spaced apart from each other in each of the first and second directions D1 and D2, and may be arranged in a lattice pattern or a honeycomb pattern in a plan view.

Each of the contact plug 240 and the landing pad 260 may include a conductive material (e.g., metal, metal nitride, metal silicide, etc.), or polysilicon. When the contact plug 240 and/or the landing pad 260 include polysilicon, an ion implantation process and a second heat treatment process may be further performed on the contact plug 240 and/or the landing pad 260. The second heat treatment process may be performed by a rapid thermal annealing (RTA) process at a temperature equal to or greater than about 600°C.

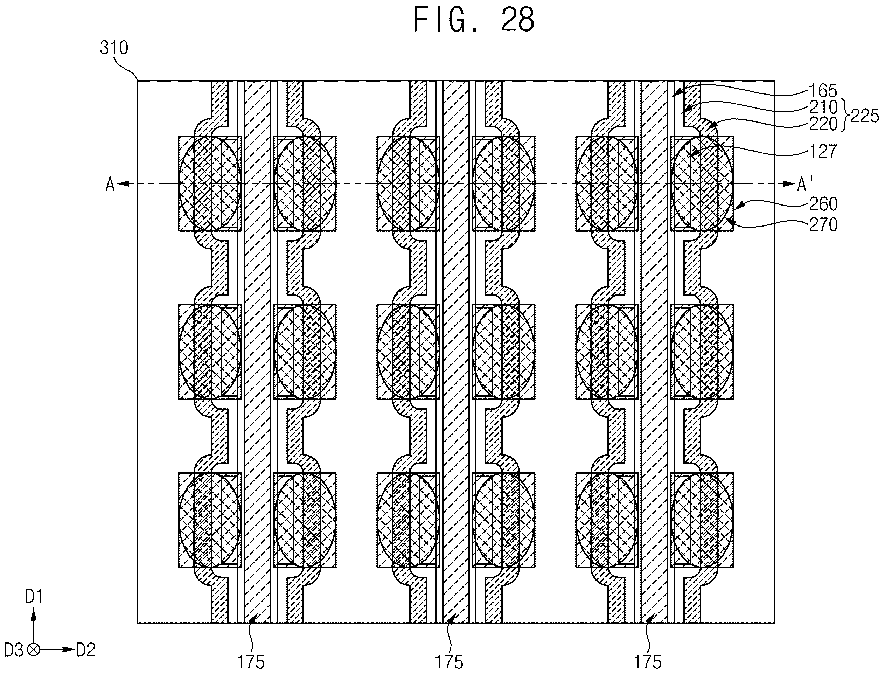

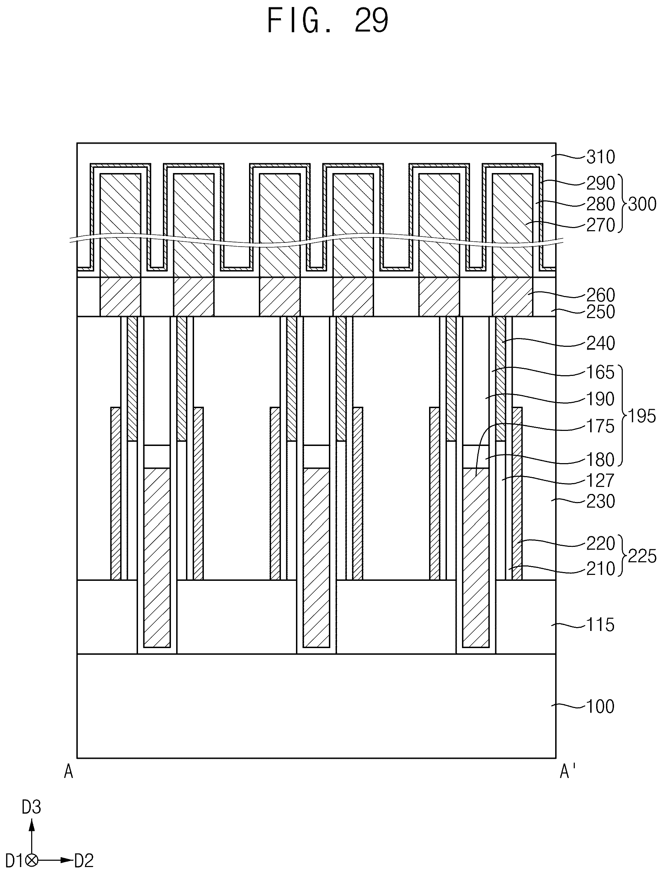

Referring to FIGS. 28 and 29, a first capacitor electrode 270 may be formed to contact an upper surface of the landing pad 260, a dielectric pattern 280 may be formed on an upper surface and a sidewall of the first capacitor electrode 270 and an upper surface of the first insulating interlayer 250, and a second capacitor electrode 290 may be formed on the dielectric pattern 280. The first capacitor electrode 270, the dielectric pattern 280 and the second capacitor electrode 290 may collectively form a capacitor 300.

In some example embodiments, a plurality of first capacitor electrodes 270 may be formed to be spaced apart from each other in each of the first and second directions D1 and D2, and may contact the landing pads 260, respectively.

An upper plate electrode 310 may be formed on the capacitor 300.

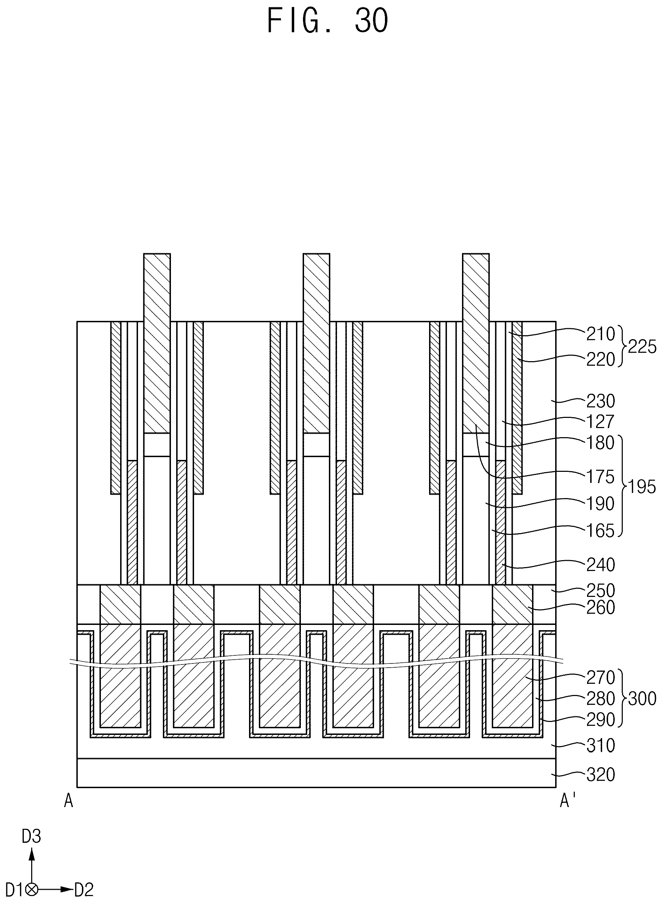

Referring to FIG. 30, a second insulating interlayer 320 and a first bonding layer may be sequentially formed on the upper plate electrode 310, a handling substrate may be bonded to the first bonding layer through a second bonding layer, and the first bulk substrate 100 and the handling substrate bonded to each other may be flipped.

Various structures on the first bulk substrate 100 are flipped upside down, and following description is based on the reversed orientation.

The first bulk substrate 100 and the buried insulation pattern 115 may be removed to expose upper surfaces of the channel 127, the second gate insulation pattern 210, the second gate electrode 220 and the gate division pattern 230, and a surface of an upper portion of the first gate insulation pattern 165 may also be exposed. The exposed upper portion of the first gate insulation pattern 165 may be removed to expose an upper portion of the first gate electrode 175.

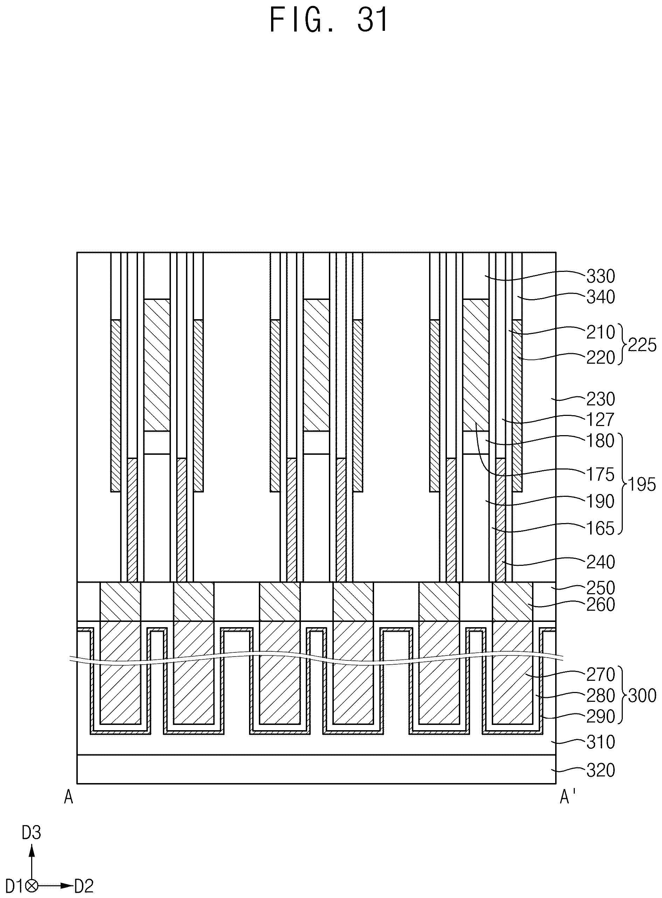

Referring to FIG. 31, an etching process (e.g., a metal etch back (MEB) process) may be performed on the first and second gate electrodes 175 and 220 to partially remove the first and second gate electrodes 175 and 220, and thus first and second recesses may be formed.

First and second insulation patterns 330 and 340 may be formed in the first and second recesses, respectively.

FIG. 31 shows that an upper surface of the first gate electrode 175 is higher than an upper surface of the second gate electrode 220, however, the inventive concepts are not limited thereto. In some example embodiments, the upper surface of the first gate electrode 175 may be lower than or substantially coplanar with the upper surface of the second gate electrode 220 according to surroundings of the etching process, materials or widths of the first and second gate electrodes 175 and 220, etc.

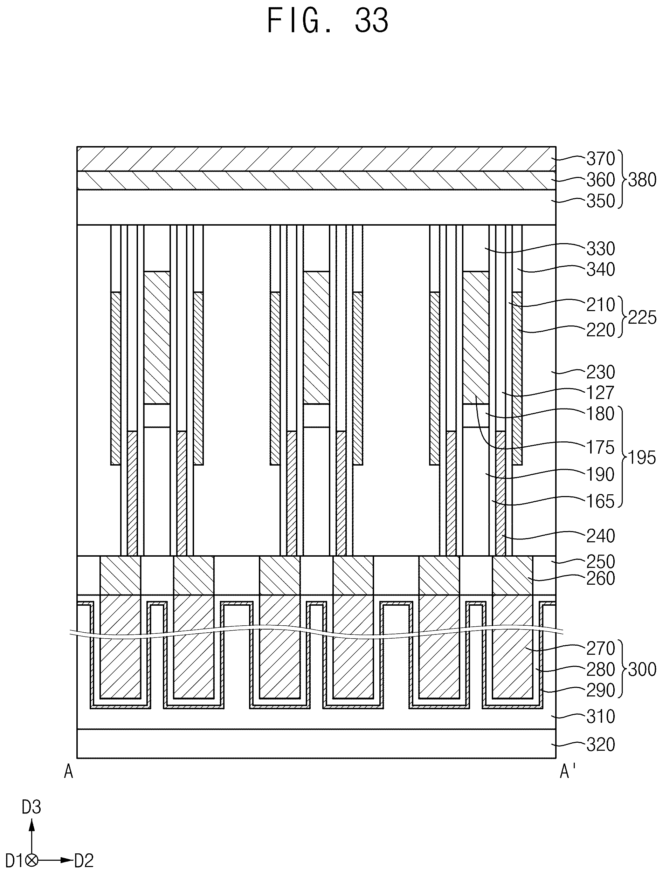

Referring to FIGS. 32 and 33, a first conductive layer, a bit line barrier layer and a second conductive layer may be sequentially stacked on the first and second gate insulation patterns 165 and 210, the first and second insulation patterns 330 and 340 and the channel 127, and may be patterned by an etching process to form a first conductive pattern 350, a bit line barrier pattern 360 and a second conductive pattern 370, respectively, which may collectively form a bit line structure 380.

In some example embodiments, the bit line structure 380 may extend in the second direction D2, and a plurality of bit line structures 380 may be formed to be spaced apart from each other in the first direction D1. A third opening 390 may be formed between neighboring ones (e.g., a corresponding adjacent pair) of the bit line structures 380 in the first direction D1 to expose the upper surfaces of the first and second gate insulation patterns 165 and 210, the first and second insulation patterns 330 and 340 and the channel 127.

Referring to FIGS. 1 to 3 again, a third insulation layer may be formed on the bit line structure 380, the first and second gate insulation patterns 165 and 210, the first and second insulation patterns 330 and 340 and the channel 127, a bit line shield layer may be formed on the third insulation layer to fill the third opening 390 to have an upper surface higher than an uppermost surface of the third insulation layer, and may be partially removed to form a bit line shield structure 410 and a third insulation pattern 400, respectively.

The bit line shield structure 410 may include a bit line shield plate 430 having an upper surface higher than an upper surface of the third insulation pattern 400, and a bit line shield fin 420 having a lower surface higher than a lower surface of the third insulation pattern 400. In some example embodiments, the bit line shield plate 430 may have a shape of a flat plane, and a plurality of bit line shield fins 420, each of which may extend in the second direction D2, may be spaced apart from each other in the first direction D1.

After flipping the handling substrate, the handling substrate and the first and second bonding layers may be removed to complete the fabrication of the semiconductor device.

As illustrated above, the first opening 150 may be formed on the first bulk substrate 100, the first gate insulation pattern 165 may be formed on an inner wall of the first opening 150, and the first gate electrode 175, the gate barrier pattern 180 and the capping pattern 190 may be sequentially stacked in the first opening 150. The other processes including the first and second heat treatment processes may be performed to form the channel 127, the second gate insulation pattern 210 and the second gate electrode 220 on the outer sidewall in the second direction D2 of the first gate insulation pattern 165, the first bulk substrate 100 may be flipped, the first and second gate electrodes 175 and 220 may be partially removed by an MEB process to form the first and second recesses exposing the upper surfaces of the first and second gate electrodes 175 and 220, and the first and second insulation patterns 330 and 340 may be formed in the first and second recesses, respectively. The capping pattern 190 may be formed by a CVD process to include excess oxygen.

If the gate barrier pattern 180 is not formed, excess oxygen of the capping pattern 190 may be diffused into the first gate electrode 175 by the first and second heat treatment processes, and thus, during the MEB process, the first gate electrode 175 may not be easily removed, and a depth of the first recess and a thickness of the first insulation pattern 330 may not have desired levels.

However, in some example embodiments, the gate barrier pattern 180 may be formed between the first gate electrode 175 and the capping pattern 190, so that the diffusion of the excess oxygen in the capping pattern 190 may be reduced or prevented. Accordingly, during the MEB process, the first gate electrode 175 may be easily removed, and the depth of the first recess and the thickness of the first insulation pattern 330 may have desired levels.

According to an example embodiment, a method of manufacturing a semiconductor device may include forming a bit line structure extending in a first direction, forming a first gate structure including a first gate electrode, a gate barrier pattern, a capping pattern and a first gate insulation pattern on the bit line structure such that the first gate electrode extends in a second direction crossing the first direction, the gate barrier pattern is disposed on the first gate electrode, the capping pattern is disposed on the gate barrier pattern, and the first gate insulation pattern is disposed on the bit line structure and on sidewalls in the first direction of the first gate electrode, the gate barrier pattern and the capping pattern, forming a channel layer on the bit line structure to extend in a third direction perpendicular to the first and second directions on a sidewall in the first direction of the first gate structure, forming a second gate structure including a second gate insulation pattern and a second gate electrode such that the second gate insulation pattern is disposed on the bit line structure and on a sidewall in the first direction of the channel, and the second gate electrode is disposed on the bit line structure and on a sidewall in the first direction of the second gate insulation pattern.

According to an example embodiment, the forming of the channel forms the channel such that an upper surface of the channel is higher than an upper surface of the gate barrier pattern.

According to an example embodiment, the gate barrier pattern may include a nitride, and the capping pattern may include an oxide.

Embodiments are set out in the following Clauses:
Clause 1. A semiconductor device comprising:
   a bit line structure extending in a first direction;
   a first insulation pattern, a first gate electrode, a gate barrier pattern and a capping pattern sequentially stacked in a third direction on the bit line structure, each of the first insulation pattern, the first gate electrode, the gate barrier pattern and the capping pattern extending in a second direction crossing the first direction, and the third direction being perpendicular to the first and second directions;
   a first gate insulation pattern on the bit line structure, the first gate insulation pattern being on sidewalls in the first direction of the first insulation pattern, the first gate electrode, the gate barrier pattern and the capping pattern;
   a channel on the bit line structure, the channel extending in the third direction on a sidewall in the first direction of the first gate insulation pattern;
   a second gate insulation pattern on the bit line structure, the second gate insulation pattern being on a sidewall in the first direction of the channel; and
   a second gate electrode on the bit line structure, the second gate electrode being on a sidewall in the first direction of the second gate insulation pattern,
   wherein the gate barrier pattern includes a first insulating material, and
   wherein the capping pattern includes a second insulating material different from the first insulating material.
Clause 2. The semiconductor device according to Clause 1, wherein the capping pattern includes oxide, and the gate barrier pattern includes nitride.
Clause 3. The semiconductor device according to Clause 1 or Clause 2, wherein
   an upper surface of the first gate insulation pattern is coplanar with an upper surface of the capping pattern, and
   a lower surface of the first gate insulation pattern is coplanar with a lower surface of the first insulation pattern.
Clause 4. The semiconductor device according to any preceding Clause, wherein the sidewalls in the first direction of the first insulation pattern, the first gate electrode, the gate barrier pattern and the capping pattern are aligned with each other in the third direction.
Clause 5. The semiconductor device according to Clause 14, further comprising:
   a contact plug,
   wherein upper surfaces of the capping pattern, the first gate insulation pattern, the contact plug and the second gate insulation pattern are coplanar with each other.
Clause 6. A semiconductor device comprising:
   bit line structures spaced apart from each other in a first direction, each of the bit line structures extending in a second direction crossing the first direction;
   a first insulation pattern on the bit line structures and extending in the first direction, the first insulation pattern including a first insulating material;
   a first gate electrode on the first insulation pattern and extending in the first direction;
   a gate barrier pattern on the first gate electrode and extending in the first direction, the gate barrier pattern including nitride;
   a capping pattern on the gate barrier pattern and extending in the first direction, the capping pattern including oxide;
   first gate insulation patterns on the bit line structures, the first gate insulation patterns being on opposite sidewalls in the second direction of each of the first insulation pattern, the first gate electrode, the gate barrier pattern and the capping pattern, respectively;
   channels on the bit line structures, the channels being on sidewalls in the second direction of the first gate insulation patterns, respectively, each of the channels extending in a third direction perpendicular to the first and second directions;
   contact plugs on the channels, respectively;
   second gate insulation patterns on the bit line structures, the second gate insulation patterns on sidewalls in the second direction of the channels, respectively, and each of the second gate insulation patterns extending in the first direction;
   second insulation patterns on the bit line structures, the second gate insulation patterns being on sidewalls in the second direction of the second gate insulation patterns, respectively, and each of the second insulation patterns extending in the first direction and including a second insulating material;
   second gate electrodes on the second insulation patterns, respectively, each of the second gate electrodes extending in the first direction;
   landing pads on the contact plugs, respectively; and
   capacitors on the landing pads, respectively.
Clause 7. The semiconductor device according to Clause 6, wherein
   upper surfaces of the capping pattern, the first gate insulation patterns, the contact plugs and the second gate insulation patterns are coplanar with each other, and
   lower surfaces of the first insulation pattern, the first gate insulation patterns, the channels, the second gate insulation patterns and the second insulation patterns are coplanar with each other.
Clause 8. The semiconductor device according to Clause 6 or Clause 7, wherein the first insulation pattern and second insulation patterns include a same material.
Clause 9. The semiconductor device according to any of Clauses 6-8, wherein a thickness in the third direction of the gate barrier pattern is in a range of 10Å to 60Å.
Clause 10. The semiconductor device according to any of Clauses 6-9, wherein each of the second gate insulation patterns contacts opposite sidewalls in the first direction of a corresponding one of the channels and a sidewall in the second direction of a corresponding one of the first gate insulation patterns.

The foregoing is illustrative of some example embodiments and is not to be construed as limiting thereof. Although a few example embodiments have been described, those skilled in the art will readily appreciate that many modifications are possible in the disclosed example embodiments without materially departing from the novel teachings and advantages of the present inventive concepts. Accordingly, all such modifications are intended to be included within the scope of the present inventive concepts as defined in the claims. In the claims, means-plus-function clauses are intended to cover the structures described herein as performing the recited function and not only structural equivalents but also equivalent structures. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. A semiconductor device comprising:
a bit line structure (380) extending in a first direction;
a first gate structure (195) including
a first gate electrode (175) extending in a second direction crossing the first direction, the first gate electrode (175) being on the bit line structure (380),
a gate barrier pattern (180) on the first gate electrode (175), the gate barrier pattern (180) including a nitride,
a capping pattern (190) on the gate barrier pattern (180), the capping pattern (190) including an oxide, and
a first gate insulation pattern (165) on the bit line structure (380), the first gate insulation pattern (165) being on sidewalls in the first direction of the first gate electrode (175), the gate barrier pattern (180) and the capping pattern (190);
a channel (127) on the bit line structure (380), the channel (127) extending in a third direction perpendicular to the first and second directions on a sidewall in the first direction of the first gate structure (195); and
a second gate structure (225) including
a second gate insulation pattern (210) on the bit line structure (380), the second gate insulation pattern (210) being on a sidewall in the first direction of the channel (127), and
a second gate electrode (220) on the bit line structure (380), the second gate electrode (220) being on a sidewall in the first direction of the second gate insulation pattern (210).

2. The semiconductor device according to claim 1, wherein a thickness in the third direction of the gate barrier pattern (180) is in a range of 10Å to 60Å.

3. The semiconductor device according to claim 1 or claim 2, wherein an upper surface of the channel (127) is higher than an upper surface of the gate barrier pattern (180).

4. The semiconductor device according to any preceding claim, further comprising:
a first insulation pattern (330) contacting an upper surface of the bit line structure (380) and a lower surface of the first gate electrode (175), the first insulation pattern (330) including a first insulating material,
wherein the first gate insulation pattern (165) contacts a sidewall of the first insulation pattern (330).

5. The semiconductor device according to claim 4, further comprising:
a second insulation pattern (340) contacting the upper surface of the bit line structure (380) and a lower surface of the second gate electrode (220), the second insulation pattern (340) including a second insulating material.

6. The semiconductor device according to claim 5, wherein the first and second insulating materials include a same material.

7. The semiconductor device according to claim 5 or claim 6, wherein an upper surface of the first insulation pattern (330) is lower than an upper surface of the second insulation pattern (340).

8. The semiconductor device according to any preceding claim, further comprising:
a gate division pattern (230) on the bit line structure (380), the gate division pattern (230) including
a first portion covering a sidewall in the first direction of the second gate electrode (220); and
a second portion on and contacting the first portion, the second portion covering an upper surface of the second gate electrode (220), a first width in the first direction of the second portion being greater than a second width in the first direction of the first portion.

9. The semiconductor device according to any preceding claim, further comprising:
a contact plug (240) contacting an upper surface of the channel (127);
a landing pad (260) on the contact plug (240); and
a capacitor (300) on the landing pad (260).

10. The semiconductor device according to claim 9, wherein the contact plug (240) includes doped polysilicon, and the landing pad includes metal (260).

11. The semiconductor device of any preceding claim wherein:
the semiconductor device comprises a first insulation pattern (330);
the first insulation pattern (330), the first gate electrode (175), the gate barrier pattern (180) and the capping pattern (190) are sequentially stacked in the third direction on the bit line structure (380);
each of the first insulation pattern (330), the first gate electrode (175), the gate barrier pattern (180) and the capping pattern (190) extend in the second direction;
the first gate insulation pattern (165) is on sidewalls in the first direction of the first insulation pattern (330); and
the channel (127) extends in the third direction on a sidewall in the first direction of the first gate insulation pattern (165).

12. The semiconductor device according to claim 11, wherein
an upper surface of the first gate insulation pattern (165) is coplanar with an upper surface of the capping pattern (190), and
a lower surface of the first gate insulation pattern (165) is coplanar with a lower surface of the first insulation pattern (330).

13. The semiconductor device according to claim 11 or claim 12, wherein the sidewalls in the first direction of the first insulation pattern (330), the first gate electrode (175), the gate barrier pattern (180) and the capping pattern (190) are aligned with each other in the third direction.

14. The semiconductor device according to claim 13, further comprising:
a contact plug (240),
wherein upper surfaces of the capping pattern (190), the first gate insulation pattern (165), the contact plug (240) and the second gate insulation pattern (210) are coplanar with each other.
